# EUROPEAN PATENT SPECIFICATION

(11) **EP 2 238 178 B1**
(45) Date of publication and mention of the grant of the patent: **10.09.2014**
(21) Application number: 09706026.3
(22) Date of filing: 06.01.2009
(51) Int. Cl.: C08F 2/50, G03F 7/031, C07D 487/04

(54) **PHOTOLATENT AMIDINE BASES FOR REDOX CURING OF RADICALLY CURABLE FORMULATIONS**
PHOTOLATENTE AMIDINBASEN ZUR REDOX-HÄRTUNG RADIKAL HÄRTBARER FORMULIERUNGEN
BASES D'AMIDINE PHOTO-LATENTES POUR LE DURCISSEMENT REDOX DE FORMULATIONS RADICALEMENT DURCISSABLES

(30) Priority: 28.01.2008 EP 08150721
(43) Date of publication of application: 13.10.2010
(73) Proprietor: BASF SE, 67056 Ludwigshafen (DE)
(72) Inventor: STUDER, Katia, F-68170 Rixheim (FR); DIETLIKER, Kurt, CH-4123 Allschwil (CH); JUNG, Tunja, 67251 Freinsheim (DE)
(86) International application number: PCT/EP2009/050066
(87) International publication number: WO 2009/095282

(56) References cited:
- EP-A- 0 898 202
- WO-A-03/033500

## Description

The invention pertains to radically curing compositions, which besides the initiator for activation of the crosslinking comprise a photolatent amidine base.

Radically curing 2-pack formulations, based on unsaturated oligomers are known in the art. A redox reaction, usually involving a peroxide initiator and a promoter (e.g. a tertiary amine and/or saccharin or a transition metal or a combination of these compounds), initiates the cure process for such systems as for example described in EP0739963*.* The addition of a promoter allows the reaction to be initiated at a much lower temperature compared to the sole peroxide initiator.

WO06/092434 teaches radically curable coating compositions comprising an aryl-amine and a peroxide compound, while similar compositions comprising a peroxide and i.a. an amidine are known from US3018266*.*

The reduction of the peroxide leads to the formation of free radicals able to initiate the cure reaction of an unsaturated oligomer such as for example an acrylate or an unsaturated polyester. The extreme reactivity of such systems leads to an ultrafast hardening under anaerobic conditions at room temperature at the expense of the formulation stability. The reaction being strongly inhibited by oxygen, storing of the formulation in the presence of a high oxygen concentration (e.g. half-filled bottle) allows keeping the formulation stable: the storage of the formulation as a 1-pack system remains however quite complex. Once the system is confined between two closely fitting substrates, the cure reaction starts and proceeds rapidly. Some recent developments focusing on anaerobic systems aim at combining anaerobic curing and light curing. US6664357*,* for example, describes a method combining these two processes for manufacturing a dual-cure adhesive, employing a composition comprising an acrylate monomer, a chelating agent and an accelerator. Similar attempts are described by /. Sideridou in Marcomolecules, 39, 2006, 2072 where a tertiary amine both reduces the thermal peroxide initiator for the redox initiation and serves as hydrogen donor for the UV-curing in combination with camphorquinone.

However, industrial application employing both curing methods within one process is still quite marginal.

Thus, finding the right balance between cure speed and formulation stability at low temperature still is a major concern for anaerobic redox-curing formulations.

Surprisingly, it has been found that a radically polymerizable formulation, that is an acrylate formulation, comprising an amidine base, for example a photolatent amidine base, or a photolatent amine base in combination with a free radical initiator, which is able to be reduced by amines and/or amidines, in particular a peroxide initiator, is stable, while the cure can be initiated by light exposure under oxygen-free conditions.

Document WO 03/033500 discloses 1,3-diamine compounds that can be photochemically converted into amidines by absorbing light in the wavelength range from 200 to 650 nm and compositions that in addition to the above photolatent amidine can comprise radically polymerisable compounds such as mono- or polyacrylates, as well as photosensitizers such as benzophenones. WO 03/033500 is silent about the addition of a peroxide.

Document EP 0 898 202 relates to curable compositions comprising 1-5 wt.% α-aminoketone as latent bases as well as radically polymerisable components and radically polymerisable compounds. Additional photoinitiators can be included as well as a photosensitizer such as a benzophenone. While reference is made to additional free radical initiators, no peroxide is cited.

Subject of the invention therefore is a composition comprising
(a1) a photolatent amidine base; **or**
(a2) a photolatent amine base; **or**
(a3) a mixture of (a1) and (a2); **and**
(b) a radically polymerizable compound; **and**
(c) a peroxide; providing a fairly stable one pack formulation.

The photolatent amidines allow a light-activation of the redox curing reactions. Once mixed to reducable free-radical initiators, e.g. peroxide initiators in an acrylate formulation, these components give a stable formulation and the amidine liberated under UV-exposure accelerates the curing in the presence of the peroxide initiator under O₂-free conditions. Benefit of such systems is the good stability of the formulation, as there is no further need of storing it in the presence of oxygen.

Employing photolatent amidine to set off the reduction of a peroxide initiator to further initiate the polymerization of an unsaturated oligomer further enables a fast cure at low temperature in an oxygen-free environment after light activation while keeping the formulation stable in the dark.

In the present invention a photolatent base (a1) or (a2), in particular a photolatent amidine base (a1), is used as the activator, activated by radiation, of redox-curing reactions. Examples of photolatent bases comprise compounds of the formula I,

Z-A (I),

wherein
**Z** is a photolabile group; and
**A** is an amidine or amine base precursor group, covalently bonded to Z.

**A** as a base precursor group is for example

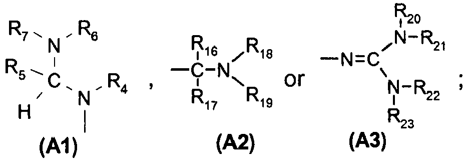

**Z** as a photolabile group is for example 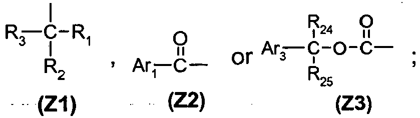 and provided that in the compounds of formula I the groups A1 are combined with a group Z1; the groups A2 are combined with a group Z2; and the groups A3 are combined with a group Z3; **R₁** is an aromatic or heteroaromatic radical which is capable of absorbing light in the wavelength range from 200 to 650 nm and which is unsubstituted or substituted by one ore more C₁-C₂₀-alkyl, C₂-C₂₀-alkenyl, C₂-C₁₈-alkinyl, C₁-C₂₀-haloalkyl, NR₁₀R₁₁, CN, OR₁₀, SR₁₀, COR₁₁, COOR₁₂, halogen or a substituent 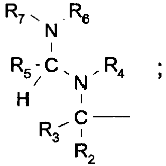 or R₁ is 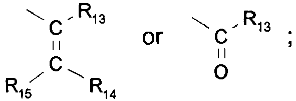 **R₂** and **R₃** independently of each other are hydrogen, C₁-C₁₈-alkyl, C₁-C₁₈-alkenyl, C₃-C₁₈-alkinyl or phenyl which is unsubstituted or substituted by one or more C₁-C₁₈-alkyl, CN, OR₁₀, SR₁₀, halogen, or C₁-C₁₈-haloalkyl;
**R₅** is C₁-C₁₈-alkyl or NR₁₀R₁₁;
**R₄, R₆,** and **R₇** independently of one another are hydrogen or C₁-C₁₈-alkyl; or
**R₄** and **R₆** together form a C₂-C₁₂-alkylene bridge that is unsubstituted or substituted by one ore more C₁-C₄-alkyl; or
**R₅** and **R₇,** independently of R₄ and R₆, together form a C₂-C₁₂alkylene bridge which is unsubstituted or substituted by one ore more C₁-C₄-alkyl; or, if R₅ is NR₁₀R₁₁, R₇ and R₁₁ together form a C₂-C₁₂-alkylene bridge which is unsubstituted or substituted by one or more C₁-C₄-alkyl;
**R₁₀, R₁₁** and **R₁₂** independently of each other are hydrogen or C₁-C₁₈alkyl;
**R₁₃** is an aromatic or heteroaromatic radical which is capable of absorbing light in the wavelength range from 200 to 650 nm and which is unsubstituted or substituted by one or more C₁-C₁₈-alkyl, C₂-C₁₈-alkenyl, C₂-C₁₈-alkinyl, C₁-C₁₈-haloalkyl, NR₁₀R₁₁, CN, OR₁₀, SR₁₀, COR₁₁, COOR₁₂, or halogen;
**R₁₄** is hydrogen or C₁-C₁₈-alkyl;
**R₁₅** is hydrogen, C₁-C₁₈-alkyl or phenyl which is unsubstituted or substituted by one or more C₁-C₁₈-alkyl, vinyl, C₃-C₁₈-alkenyl, C₃-C₁₈-alkinyl, C₁-C₁₈-haloalkyl, phenyl, NR₁₀R₁₁, CN, OR₁₀, SR₁₀, COR₁₁, COOR₁₂, or halogen;
**Ar₁** is an aromatic radical of formula V, VI, VII or VIII 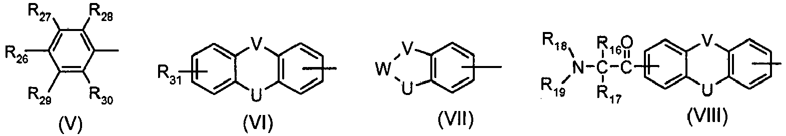 **U** is O, S or N(R₃₂);
**V** has one of the meanings given for U or is CO, CH₂, CH₂CH₂, C₂-C₆-alkylidene or a direct bond;
**W** is C₁-C₇-alkylene or C₂-C₆-alkylidene;
**R₁₆** and **R₁₇** are each independently of each other cyclopentyl, cyclohexyl, unsubstituted C₁-C₁₂-alkyl; C₁-C₁₂alkyl which is substituted by OH, C₁-C₄-alkoxy, SH, CN, (CO)O(C₁-C₈-alkyl), O(CO)C₁-C₄-alkyl, phenoxy, halogen and/or phenyl;
or R₁₆ and R₁₇ are phenyl which is unsubstituted or substituted by halogen, C₁-C₁₂-alkyl and/or C₁-C₁₂-alkoxy;
or R₁₆ and R₁₇ are 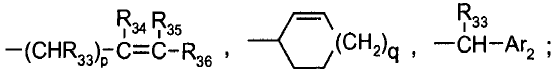 or R₁₆ and R₁₇ together are C₂-C₉-alkylene or C₃-C₉-oxaalkylene, or together form a radical of formula 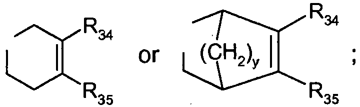 **p** is 0 or 1;
**q** is 0, 1, 2, or 3;
**y** is 1 or 2;
**Ar₂** is phenyl, naphthyl, thienyl or furyl, each of which is unsubstituted or substituted by halogen, OH, C₁-C₁₂-alkyl, C₁-C₁₂-alkoxy, (OCH₂CH₂)ₓOH, (OCH₂CH₂)ₓOCH₃, C₁-C₈-alkylthio, phenoxy, (CO)O(C₁-C₁₈-alkyl), CO(OCH₂CH₂)ₓOCH₃, phenyl or benzoyl;
or the radicals phenyl, naphthyl, thienyl or furyl are substituted by C₁-C₄-alkyl, which is substituted by OH, halogen, C₁-C₁₂-alkoxy, (CO)O(C₁-C₁₈-alkyl), CO(OCH₂CH₂)ₓOCH₃ and/or OCO(C₁-C₄-alkyl);
or the radicals phenyl, naphthyl, thienyl or furyl are substituted by C₁-C₄-alkoxy, which is substituted by (CO)O(C₁-C₁₈-alkyl) or CO(OCH₂CH₂)ₓOCH₃;
**x** is 1-20;
**R₁₈** is C₁-C₁₂-alkyl, C₃-C₅-alkenyl, C₅-C₁₂-cycloalkyl, phenyl-C₁-C₃-alkyl or C₂-C₄-alkyl which is substituted by OH, C₁-C₄-alkoxy, CN and/or (CO)O(C₁-C₄-alkyl);
**R₁₉** is C₁-C₁₂-alkyl, C₃-C₅-alkenyl, C₅-C₁₂-cycloalkyl, phenyl-C₁-C₃-alkyl, C₂-C₄-alkyl which is substituted by OH, C₁-C₄-alkoxy, CN and/or (CO)O(C₁-C₄-alkyl);
or R₁₉ is phenyl which is unsubstituted or substituted by C₁-C₁₂-alkyl, C₁-C₄-alkoxy or (CO)O(C₁-C₄-alkyl);
or R₁₉ together with R₁₇ is C₁-C₇-alkylene, phenyl-C₁-C₄-alkylene, o-xylylene, 2-butenylene or C₂-C₃-oxaalkylene;
or R₁₈ and R₁₉ together with the nitrogen atom to which they are linked, form a 5-, 6- or 7-membered ring which optionally is interrupted by O, S, CO or NR₃₇;
or R₁₈ and R₁₉ together are C₃-C₇-alkylene which optionally is substituted by OH, C₁-C₄-alkoxy and/or (CO)O(C₁-C₄-alkyl);
**R₂₆, R₂₇, R₂₈, R₂₉** and **R₃₀** are each independently of one another hydrogen, halogen, C₁-C₁₂-alkyl, cyclopentyl, cyclohexyl, phenyl, benzyl, benzoyl, OR₃₂, SR₃₇, SOR₃₇, SO₂R₃₇, N(R₃₈)(R₃₉), NH-SO₂R₄₂ or 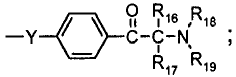 **Y** is O, S, N(R₄₀), N(R₄₀)-R₄₁-N(R₄₀) or 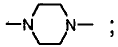 **R₃₁** is hydrogen, C₁-C₁₂-alkyl, halogen or C₂-C₈-alkanoyl;
**R₃₂** is hydrogen, C₁-C₁₂-alkyl, (CO)O(C₁-C₄-alkyl), (CH₂CH₂O)ₓH, C₂-C₈-alkanoyl, C₃-C₁₂-alkenyl, cyclohexyl, hydroxycyclohexyl phenyl-C₁-C₃-alkyl, Si(C₁-C₈-alkyl)ᵣ(phenyl)₃₋ᵣ or C₂-C₆-alkyl which is substituted by SH, CN, OH, C₁-C₄-alkoxy, C₃-C₆-alkenoxy, OCH₂CH₂CN, OCH₂CH₂COO(C₁-C₄-alkyl), COOH and/or O(CO)-C₁-C₄-alkyl which is unsubstituted or substituted by SH;
or R₃₂ is phenyl which is unsubstituted or substituted by halogen, C₁-C₁₂-alkyl and/or C₁-C₄-alkoxy;
**r** is 1, 2 or 3;
**R₃₃** is hydrogen, C₁-C₆-alkyl or phenyl;
**R₃₄**, **R₃₅** and **R₃₆** are each independently of one another hydrogen or C₁-C₄-alkyl, or R₃₄ and R₃₅ together are C₃-C₇-alkylene;
**R₃₇** is hydrogen, C₁-C₁₂-alkyl, C₃-C₁₂-alkenyl, cyclohexyl, phenyl-C₁-C₃-alkyl, OCH₂CH₂COO(C₁-C₄-alkyl) or C₂-C₁₂-alkyl which is substituted by SH, OH, CN, COOH, (CO)O(C₁-C₄-alkyl), C₁-C₄-alkoxy, OCH₂CH₂CN and/or O(CO)-C₁-C₄-alkyl which is unsubstituted or substituted by SH; or R₃₇ is C₁-C₁₂-alkyl which is interrupted by S or O; or R₃₇ is phenyl which is unsubstituted or substituted by halogen, SH, C₁-C₁₂alkyl and/or C₁-C₄-alkoxy; **R₃₈** and **R₃₉** are each independently of the other C₁-C₁₂-alkyl, C₂-C₄-hydroxyalkyl, C₂-C₁₀-alkoxyalkyl, C₃-C₅-alkenyl, C₅-C₁₂-cycloalkyl, phenyl-C₁-C₃-alkyl, C₂-C₃-alkanoyl, benzoyl, O(CO-C₁-C₈)ₒ-OH or phenyl which is unsubstituted or substituted by halogen, C₁-C₁₂-alkyl and/or C₁-C₄-alkoxy;
or **R₃₈** and **R₃₉** together are C₂-C₈-alkylene which optionally is interrupred by O, N(R₄₃) or S, or R₃₈ and R₃₉ together are C₂-C₈-alkylene which optionally is substituted by hydroxyl, C₁-C₄-alkoxy and/or (CO)O(C₁-C₄-alkyl);
**o** is an integer from 1 to 15;
**R₄₀** is C₁-C₈-alkyl, C₃-C₅-alkenyl, phenyl-C₁-C₃-alkyl, C₁-C₄-hydroxyalkyl or phenyl;
**R₄₁** is C₂-C₁₆-alkylene which optionally is interrupted by one or more O or S;
**R₄₂** is C₁-C₁₈-alkyl, naphthyl or phenyl which is unsubstituted or substituted by halogen, C₁-C₁₂-alkyl and/or C₁-C₈-alkoxy; and
**R₄₃** is C₁-C₈-alkyl, phenyl-C₁-C₃-alkyl, CH₂CH₂-COO(C₁-C₈-alkyl), CH₂CH₂CN, CH₂CH₂-COO(CH₂CH₂O)ₒ-H or 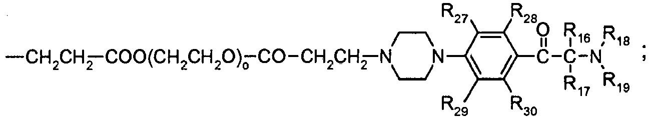 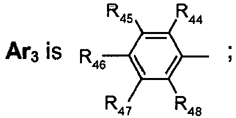 **R₂₀, R₂₁, R₂₂, R₂₃, R₂₄, R₂₅, R₄₄, R₄₅, R₄₆, R₄₇** and **R₄₈** idependently of one another are a group selected from hydrogen, alkyl, aryl, aryl-alkyl, halogen, alkyl-O-, aryl-O-, aryl-alkyl-O-, aryl-N-, alkyl-N-, aryl-alkyl-N-, alkyl-S-, aryl-S-, aryl-alkyl-S-, NO-, cyano, carboxylic ester, carboxylic amide, ketones or aldehydes and wherein R₂₀, R₂₁, R₂₂ and/or R₂₃ optionally form a ring structure and wherein R₂₄, R₂₅, R₄₄, R₄₅, R₄₆, R₄₇ and R₄₈ optionally independently from R₂₀, R₂₁, R₂₂ and R₂₃ form one or more ring structures.

Accordingly, interesting as photolatent base in the context of the present invention are compounds of the formula Ia, Ib and Ic

Al-Z1 (Ia)

A2-Z2 (Ib)

A3-Z3 (Ic),

wherein
A1, A2, A3, Z1, Z2 and Z3 are as defined above.

It is evident that photolatent base compounds may be used singly or in any combination with one another.

*C₁-C₁₈alkyl* is linear, branched or cyclic and is, for example C₁-C₁₄-, C₁-C₁₂-, C₁-C₈-, C₁-C₆- or C₁-C₄alkyl. Examples are methyl, ethyl, propyl, isopropyl, n-butyl, sec-butyl, isobutyl, tert-butyl, pentyl, hexyl, heptyl, 2,4,4-trimethylpentyl, 2-ethylhexyl, octyl, nonyl, decyl, dodecyl, tetradecyl, pentadecyl, hexadecyl, octadecyl and icosyl. The cyclic alkyl in the context of the present application is to be understood as alkyl which at least comprises one ring. For example cyclopropyl, methyl-cyclopentyl, cyclopentyl, cyclohexyl, methyl- or dimethylcyclohexyl, cyclooctyl, cyclo-dodecyl, especially cyclopentyl and cyclohexyl, preferably cyclohexyl are also meant. Further examples are structures like 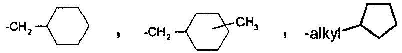 e.g. 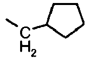 or 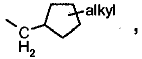 as well as bridged or fused ring systems, e.g. 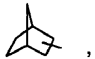 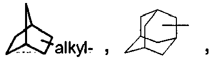 etc. are also meant to be covered by the term.

*C₂-C₁₂alkyl interrupted by one or more* O *or* S is for example interrupted 1-6 or once or twice by O or S. In case the groups are interrupted by more than one O, said O-atoms are seper-ated from one another by at least one methylene group, i.e. the O-atoms are nonconsecutive. Examples are the following structural units -CH₂-O-CH₃, -CH₂CH₂-O-CH₂CH₃, -[CH₂CH₂O]_{y}-CH₃, with y = 1-5, or -CH₂-S-CH₃, -CH₂CH₂-S-CH₂CH₃.

*C₁-C₁₈haloalkyl* is linear or branched C₁-C₁₈-, C₁-C₁₄-, C₁-C₁₂-, C₁-C₁₀-, C₁-C₈-, C₁-C₆- or C₁-C₄-alkyl mono- or poly-substituted by halogen, the alkyl being, for example, as defined above. The alkyl radical is for example mono- or poly-halogenated, up to the exchange of all H-atoms by halogen. C₁-C₂₀alkyl substituted by one or more halogen is for example Cₙ[HₓHal_{y}]₂ₙ₊₁, wherein the sum of x+y = 2n+1 and Hal, is halogen, preferably F. Examples are chloromethyl, trichloromethyl, trifluoromethyl or 2-bromopropyl, especially trifluoromethyl or trichloromethyl. *C₅-C₁₂Cycloalkyl* is for example cyclopropyl, cyclopentyl, cyclohexyl, cyclooctyl, cyclo-dodecyl, especially cyclopentyl and cyclohexyl, preferably cyclohexyl. C₅-C₁₂Cycloalkyl in the context of the present application is to be understood as alkyl which at least comprises one ring. For example cyclopropyl, methyl-cyclopentyl, cyclopentyl, cyclohexyl, methyl- or dimethylcyclohexyl, cyclooctyl, especially cyclopentyl and cyclohexyl, preferably cyclohexyl are also meant. Further examples are structures like 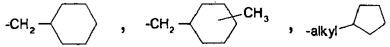 e.g. 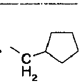 or 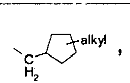 as well as bridged or fused ring systems, e.g. 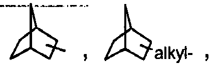 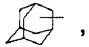 etc. are also meant to be coverd by the term.

*C₂-C₂₀-alkenyl* is for example mono or polyunsaturated, linear or branched and is for example C₂-C₁₈-, C₂-C₁₀-, C₂-C₈-, C₂-C₆- or C₂-C₄alkenyl. Examples are allyl, methallyl, vinyl, 1,1-dimethylallyl, 1-butenyl, 3-butenyl, 2-butenyl, 1,3-pentadienyl, 5-hexenyl or 7-octenyl, especially allyl or vinyl.

*C₂-C₁₈-alkinyl* is mono or polyunsaturated, linear or branched and is for example C₂-C₈-, C₂-C₆- or C₂-C₄alkinyl. Examples are ethinyl, propinyl, butinyl, 1-butinyl, 3-butinyl, 2-butinyl, pentinyl hexinyl, 2-hexinyl, 5-hexinyl, octinyl, etc..

*Halogen* is fluorine, chlorine, bromine and iodine, especially fluorine, chlorine and bromine, preferably fluorine and chlorine.

*Phenyl-C₁-C₃alkyl* is for example benzyl, phenylethyl, α-methylbenzyl, phenylpropyl or α,α-dimethylbenzyl, especially benzyl.

*C₂-C₈alkanoyl* is linear or branched and is, for example C₂-C₆- or C₂-C₄alkanoyl. Examples are acetyl, propionyl, butanoyl, isobutanoyl, pentanoyl, hexanoyl, heptanoyl or octanoyl, preferably acetyl.

*C₂-C₁₀alkoxyalkyl* is C₂-C₁₀alkyl, which is interrupted by one O-atom. C₂-C₁₀alkyl has the same meanings as given above for C₁-C₂₀alkyl up to the corresponding number of C-atoms. Examples are methoxymethyl, methoxyethyl, methoxypropyl, ethoxymethyl, ethoxyethyl, ethoxypropyl, porpoxymethyl, prpopxyethyl, propoxypropyl.

*C₁-C₁₂alkylene* and *C₂-C₁₂alkylene* is linear or branched for example C₁-C₁₈-, C₁-C₁₂-, C₁-C₁₀-, C₁-C₈-, C₁-C₆-, C₁-C₄alkylene, or C₂-C₁₈-, C₂-C₁₂-, C₂-C₁₀-, C₂-C₈-, C₂-C₆-, C₂-C₄alkylene for example methylene, ethylene, propylene, 1-methylethylene 1,1-dimethylethylene, butylene, 1-methylpropylene, 2-methyl-propylene, pentylene, hexylene, heptylene, octylene, nonylene, decylene or dodecylene.

*C₂-C₈alkylene which is interrupted one or more times by O, NR₄₃ or* S is, for example, interrupted 1-6 times or once or twice by O, S or NR₄₃. This produces structural units such as, for example, -CH₂-O-CH₂-, -CH₂-S-CH₂-, -CH₂-N(CH₃)-CH₂-, -CH₂CH₂-O-CH₂CH₂-, -[CH₂CH₂O]_{y}-, -[CH₂CH₂O]_{y-1}-CH₂-, where y = 1-4, etc.. Interrupting O-atoms are non-successive.

*C₂-C₃oxaalkylene* refers to C₂-C₃alkylene which is interrupted by -O-, and is, for example, -CH₂-O-CH₂-, -CH₂-CH₂-O-CH₂-, -CH₂-O-CH₂-O-CH₂- or -CH₂-O-CH₂CH₂.

*C₂-C₆-alkylidene* is a divalent group formed from alkanes by removal of two hydrogen from the same carbon atom, the free valences forming a double bond, e.g. CH₃CH=, CH₃CH₂CH=, etc.. The alkyl part in said radical is linear or branched.

*Phenyl-C₁-C₄-alkylene* has two free valencies, one positioned at the phenyl ring, the other present in the alkylene group: 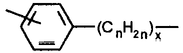 with x = 1 to 4.

*C₁-C₁₂alkoxy* is linear or branched and is for example C₁-C₁₀-, C₁-C₈-, C₁-C₆- or C₁-C₄-alkoxy. Examples are methoxy, ethoxy, propoxy, isopropoxy, n-butyloxy, sec-butyloxy, iso-butyloxy, tert-butyloxy, pentyloxy, hexyloxy, heptyloxy, 2,4,4-trimethylpentyloxy, 2-ethylhexyloxy, octyloxy, nonyloxy, decyloxy or dodecyloxy, in particular methoxy, ethoxy, propoxy, isopropoxy, n-butyloxy, sec-butyloxy, iso-butyloxy, tert-butyloxy, especially methoxy.

*C₁-C₁₂alkylthio* is linear or branched and is for example C₁-C₁₀-, C₁-C₈-, C₁-C₆- or C₁-C₄alkylthio. Examples are methylthio, ethylthio, propylthio, isopropylthio, n-butylthio, sec-butylthio, iso-butylthio, tert-butylthio, pentylthio, hexylthio, heptylthio, 2,4,4-trimethyl-pentylthio, 2-ethylhexylthio, octylthio, nonylthio, decylthio or dodecylthio, in particular methylthio, ethylthio, propylthio, isopropylthio, n-butylthio, sec-butylthio, iso-butylthio, tert-butylthio, preferably methylthio.

*C₂-C₆alkenoxy* radicals are be mono or polyunsaturated and are for example allyloxy, methallyloxy, butenyloxy, pentenoxy, 1,3-pentadienyloxy, 5-hexenyloxy.

If R₄ and R₆ together form a *C₂-C₁₂-alkylene bridge;* or
R₅ and R₇, independently of R₄ and R₆, together form a C₂-C₁₂alkylene bridge for example the following structures are formed: 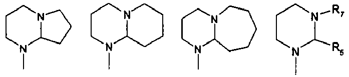 etc.

R₁ and R₁₃ as *aromatic or heteroaromatic radical* is a radical conforming to the Hückel 4n+2 rule.

Examples are phenyl, biphenylyl, naphthyl, phenanthryl, anthracyl, pyrenyl, 5,6,7,8-tetrahydro-2-naphthyl, 5,6,7,8-tetrahydro-1-naphthyl, thienyl, benzo[b]thienyl, naphtho[2,3-b]thienyl, thianthrenyl, dibenzofuryl, chromenyl, xanthenyl, thioxanthyl, phenoxathiinyl, pyrrolyl, imidazolyl, pyrazolyl, pyrazinyl, pyrimidinyl, pyridazinyl, indolizinyl, isoindolyl, indolyl, indazolyl, purinyl, quinolizinyl, isoquinolyl, quinolyl, phthalazinyl, naphthyridinyl, quinoxalinyl, quinazolinyl, cinnolinyl, pteridinyl, carbazolyl, β-carbolinyl, phenanthridinyl, acridinyl, perimidinyl, phenanthrolinyl, phenazinyl, isothiazolyl, phenothiazinyl, isoxazolyl, furazanyl, terphenyl, stilbenyl, fluorenyl and phenoxazinyl. Preferred are phenyl, biphenylyl, naphthyl, phenanthryl, anthracyl, in particular phenyl. All of the above radicals are unsubstituted or substituted by the groups as defined above.

If R₁₈ and R₁₉ together with the nitrogen atom to which they are linked, *form a 5-,* 6- *or 7-membered ring* which optionally is interrupted by O, S, CO or NR₃₇ saturated or unsaturated rings are formed, for example aziridine, pyrrole, pyrrolidine, oxazole, pyridine, 1,3-diazine, 1,2-diazine, piperidine or morpholine, preferably morpholine.

If *R₁₈ and R₁₉ or R₃₈ and R₃₉ together are C₃-C₇alkylene* for example following structures are formed 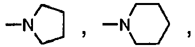 etc.. Said rings optinally are substituted by the substituents as defined above.

R₁ is for example phenyl, naphthyl, phenanthryl or anthryl, all of which are unsubstituted or substituted by one or more C₁-C₁₈-alkyl, C₂-C₁₈-alkenyl, C₂-C₁₈-alkinyl, C₁-C₁₈-haloalkyl, NR₈R₉, CN, OR₁₀, SR₁₀, COR₁₁, COOR₁₂, halogen or 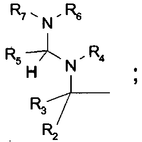 or R₁ is 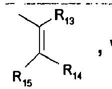 wherein R₂, R₃, R₃, R₄, R₅, R₆, R₇, R₈, R₉, R₁₀, R₁₁, R₁₂, R₁₃, R₁₄ and R₁₅ are as defined above.

In particular preferred R₁ is phenyl, which is unsubstituted or substituted by one of the substitutents as defined above. Especially preferred R₁ is unsubstituted phenyl.

The term *"and*/*or"* is intended to express the fact that not just one of the alternatives defined (substituents) may be present but that it is likewise possible for there to be two or more different alternatives (substituents) from among those defined, together, i.e. mixtures of different alternatives (substituents).

The term *"at least"* is intended to define one or more than one, e.g. one or two or three, preferably one or two.

In the description and the claims, the word *"comprising"* is to be understood to mean that a defined subject or a defined group of subjects is included but without ruling out any other substances not explicitly mentioned, unless expressly described otherwise.

In particular interesting as photolatent amidine base (a1) in the compositions according to the invention are the compounds of the formula (II), 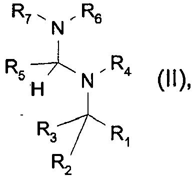 wherein
**R₁** is an aromatic or heteroaromatic radical which is capable of absorbing light in the wavelength range from 200 to 650 nm and which is unsubstituted or substituted by one or more C₁-C₁₈-alkyl, C₂-C₁₈-alkenyl, C₂-C₁₈-alkinyl, C₁-C₁₈-haloalkyl, NR₈R₉, CN, OR₁₀, SR₁₀, COR₁₁, COOR₁₂, halogen or 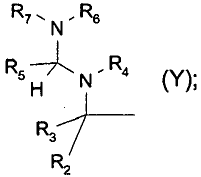 or **R₁** is 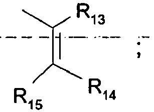 **R₂** and **R₃** independently of each other are hydrogen, C₁-C₁₈-alkyl, C₁-C₁₈-alkenyl, C₃-C₁₈-alkinyl or phenyl which is unsubstituted or substituted by one or more C₁-C₁₈-alkyl, CN, OR₁₂, SR₁₂, halogen, or C₁-C₁₈-haloalkyl;
**R₅** is C₁-C₁₈-alkyl or NR₁₀R₁₁;
**R₄, R₆, R₇, R₈** and **R₉** independently of one another are hydrogen or C₁-C₁₈-alkyl; or
**R₄** and **R₆** together form a C₂-C₁₂-alkylene bridge which is unsubstituted or substituted by one ore more C₁-C₄-alkyl; or
**R₅** and **R₇,** independently of R₄ and R₆, together form a C₂-C₁₂alkylene bridge which is unsubstituted or substituted by one ore more C₁-C₄-alkyl or, if R₅ is NR₁₀R₁₁, R₇ and R₁₁ together form a C₂-C₁₂-alkylene bridge which is unsubstituted or substituted by one ore more C₁-C₄-alkyl;
**R₁₀, R₁₁** and **R₁₂** independently of each other are hydrogen or C₁-C₁₈alkyl;
**R₁₃** is an aromatic or heteroaromatic radical which is capable of absorbing light in the wavelength range from 200 to 650 nm and which is unsubstituted or substituted by one or more C₁-C₁₈-alkyl, C₂-C₁₈-alkenyl, C₂-C₁₈-alkinyl, C₁-C₁₈-haloalkyl, NR₈R₉, CN, OR₁₀, SR₁₀, COR₁₁, COOR₁₂, or halogen;
**R₁₄** is hydrogen or C₁-C₁₈-alkyl;
**R₁₅** is hydrogen, C₁-C₁₈-alkyl or phenyl which is unsubstituted or substituted by one or more C₁-C₁₈-alkyl, vinyl, C₃-C₁₈-alkenyl, C₃-C₁₈-alkinyl, C₁-C₁₈-haloalkyl, phenyl, NR₈R₉, CN, OR₁₀, SR₁₀, COR₁₁, COOR₁₂ or halogen.

The meanings of the radicals are as described above.

Substituted phenyl, biphenylyl, naphthyl, anthryl or anthraquinonyl are for example substituted one to four times, for example one, two or three times, especially two or three times. Substituents on the phenyl ring are preferably in positions 2 or in 2,6 or 2,4,6 configuration on the phenyl ring.
Naphthyl denotes 1-naphthyl and 2-naphthyl.

In particular interesting as the photolatent base (a1) in the composition are compounds of the formula (IIa), 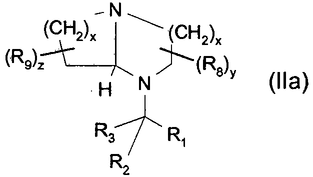 wherein
**x** is an integer from 1-5;
**y** and **z** independently of each other are an integer from 0-6;
**R₈** and **R₉** independently of each other are C₁-C₄alkyl;
**R₁, R₂** and **R₃** are as defined above.

If in the above compounds of the formula IIa more than one R₂₀ or R₂₁ is present, the definitions of said radicals have not to be similar. In other words: one R₂₀ may represent C₁alkyl, while another R₂₀ may be C₄alkyl.

Of special interest therefore are compositions as described above, comprising the compounds of formula IIa.

Emphasis has to be laid on compounds of the formula (IIb), (IIc) and (IId) 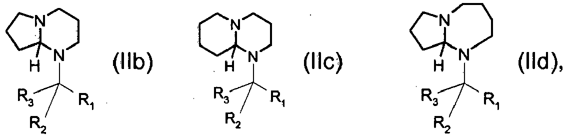 wherein
**R₁, R₂** and **R₃** are as defined above.

In particular interesting are compounds of the formula (IIb).

Interesting further are compounds of the formula (IIe) 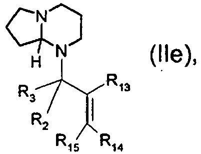 wherein
**R₂, R₃, R₁₃, R₁₄** and **R₁₅** are as defined above.

In particular preferred are

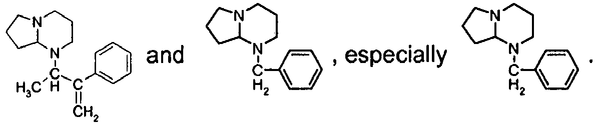

Preferably the photolatent amine base (a2) is of the formula (III) 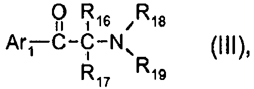 wherein
**Ar₁** is an aromatic radical of formula V, VI, VII or VIII 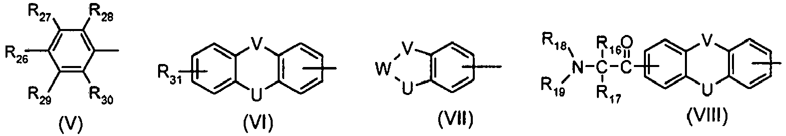 **U** is O, S or N(R₃₂);
**V** has one of the meanings given for U or is CO, CH₂, CH₂CH₂, C₂-C₆-alkylidene or a direct bond;
W is C₁-C₇-alkylene or C₂-C₆-alkylidene;
**R₁₆** and **R₁₇** are each independently of each other cyclopentyl, cyclohexyl, unsubstituted C₁-C₁₂-alkyl; C₁-C₁₂alkyl which is substituted by OH, C₁-C₄-alkoxy, SH, CN, (CO)O(C₁-C₈-alkyl), O(CO)C₁-C₄-alkyl, phenoxy, halogen and/or phenyl;
or R₁₆ and R₁₇ are phenyl which is unsubstituted or substituted by halogen, C₁-C₁₂-alkyl and/or C₁-C₁₂-alkoxy;
or R₁₆ and R₁₇ are 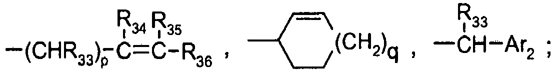 or R₁₆ and R₁₇ together are C₂-C₉-alkylene or C₃-C₉-oxaalkylene, or together form a radical of formula 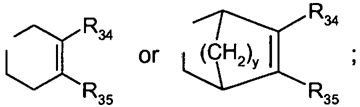 **p** is 0 or 1;
**q** is 0, 1, 2, or 3;
**y** is 1 or 2;
**Ar₂** is phenyl, naphthyl, thienyl or furyl, each of which is unsubstituted or substituted by halogen, OH, C₁-C₁₂-alkyl, C₁-C₁₂-alkoxy, (OCH₂CH₂)ₓOH, (OCH₂CH₂)ₓOCH₃, C₁-C₈-alkylthio, phenoxy, (CO)O(C₁-C₁₈-alkyl), CO(OCH₂CH₂)ₓOCH₃, phenyl or benzoyl;
or the radicals phenyl, naphthyl, thienyl or furyl are substituted by C₁-C₄-alkyl, which is substituted by OH, halogen, C₁-C₁₂-alkoxy, (CO)O(C₁-C₁₈-alkyl), CO(OCH₂CH₂)ₓOCH₃ and/or OCO(C₁-C₄-alkyl);
or the radicals phenyl, naphthyl, thienyl or furyl are substituted by C₁-C₄-alkoxy, which is substituted by (CO)O(C₁-C₁₈-alkyl) or CO(OCH₂CH₂)ₓOCH₃;
**x** is 1-20;
**R₁₈** is C₁-C₁₂-alkyl, C₃-C₅-alkenyl, C₅-C₁₂-cycloalkyl, phenyl-C₁-C₃-alkyl or C₂-C₄-alkyl which is substituted by OH, C₁-C₄-alkoxy, CN and/or (CO)O(C₁-C₄-alkyl);
**R₁₉** is C₁-C₁₂-alkyl, C₃-C₅-alkenyl, C₅-C₁₂-cycloalkyl, phenyl-C₁-C₃-alkyl, C₂-C₄-alkyl which is substituted by OH, C₁-C₄-alkoxy, CN and/or (CO)O(C₁-C₄-alkyl);
or R₁₉ is phenyl which is unsubstituted or substituted by C₁-C₁₂-alkyl, C₁-C₄-alkoxy or (CO)O(C₁-C₄-alkyl);
or R₁₉ together with R₁₇ is C₁-C₇-alkylene, phenyl-C₁-C₄-alkylene, o-xylylene, 2-butenylene or C₂-C₃-oxaalkylene;
or R₁₈ and R₁₉ together with the nitrogen atom to which they are linked, form a 5-, 6- or 7-membered ring which optionally is interrupted by O, S, CO or NR₃₇;
or R₁₈ and R₁₉ together are C₃-C₇-alkylene which optionally is substituted by OH, C₁-C₄-alkoxy and/or (CO)O(C₁-C₄-alkyl);
**R₂₆, R₂₇, R₂₈, R₂₉** and **R₃₀** are each independently of one another hydrogen, halogen, C₁-C₁₂-alkyl, cyclopentyl, cyclohexyl, phenyl, benzyl, benzoyl, OR₃₂, SR₃₇, SOR₃₇, SO₂R₃₇, N(R₃₈)(R₃₉), NH-SO₂R₄₂ or 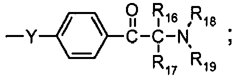 **Y** is O, S, N(R₄₀), N(R₄₀)-R₄₁-N(R₄₀) or 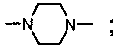 **R₃₁** is hydrogen, C₁-C₁₂-alkyl, halogen or C₂-C₈-alkanoyl;
**R₃₂** is hydrogen, C₁-C₁₂-alkyl, (CO)O(C₁-C₄-alkyl), (CH₂CH₂O)ₓH, C₂-C₈-alkanoyl, C₃-C₁₂-alkenyl, cyclohexyl, hydroxycyclohexyl phenyl-C₁-C₃-alkyl, Si(C₁-C₈-alkyl)ᵣ(phenyl)₃₋ᵣ or C₂-C₆-alkyl which is substituted by SH, CN, OH, C₁-C₄-alkoxy, C₃-C₆-alkenoxy, OCH₂CH₂CN, OCH₂CH₂COO(C₁-C₄-alkyl), COO(C₁-C₄alkyl), COOH and/or O(CO)-C₁-C₄-alkyl which is unsubstituted or substituted by SH;
or R₃₂ is phenyl which is unsubstituted or substituted by halogen, C₁-C₁₂-alkyl and/or C₁-C₄-alkoxy;
**r** is 1, 2 or 3;
**R₃₃** is hydrogen, C₁-C₆-alkyl or phenyl;
**R₃₄, R₃₅** and **R₃₆** are each independently of one another hydrogen or C₁-C₄-alkyl, or R₃₄ and R₃₅-together-are-C₃-C₇-alkylene;
**R₃₇** is hydrogen, C₁-C₁₂-alkyl, C₃-C₁₂-alkenyl, cyclohexyl, phenyl-C₁-C₃-alkyl, OCH₂CH₂COO(C₁-C₄-alkyl) or C₂-C₁₂-alkyl which is substituted by SH, OH, CN, COOH, COO(C₁-C₄-alkyl), C₁-C₄-alkoxy, OCH₂CH₂CN and/or O(CO)-C₁-C₄-alkyl which is unsubstituted or substituted by SH; or R₃₇ is C₂-C₁₂-alkyl which is interrupted by S or O; or R₃₇ is phenyl which is unsubstituted or substituted by halogen, SH, C₁-C₁₂alkyl and/or C₁-C₄-alkoxy; **R₃₈** and **R₃₉** are each independently of the other C₁-C₁₂-alkyl, C₂-C₄-hydroxyalkyl, C₂-C₁₀-alkoxyalkyl, C₃-C₅-alkenyl, C₅-C₁₂-cycloalkyl, phenyl-C₁-C₃-alkyl, C₂-C₃-alkanoyl, benzoyl, O(CO-C₁-C₈alkylene)ₒOH, or phenyl which is unsubstituted or substituted by halogen, C₁-C₁₂-alkyl and/or C₁-C₄-alkoxy;
or **R₃₈** and **R₃₉** together are C₂-C₈-alkylene which optionally is interrupted by O, N(R₄₃) or S, or R₃₈ and R₃₉ together are C₂-C₈-alkylene which optionally is substituted by hydroxyl, C₁-C₄-alkoxy and/or (CO)O(C₁-C₄-alkyl);
**o** is an integer from 1 to15;
**R₄₀** is C₁-C₈-alkyl, C₃-C₅-alkenyl, phenyl-C₁-C₃-alkyl, C₁-C₄-hydroxyalkyl or phenyl;
**R₄₁** is C₂-C₁₆-alkylene which optionally is interrupted by one or more O or S;
**R₄₂** is C₁-C₁₈-alkyl, naphthyl or phenyl which is unsubstituted or substituted by halogen, C₁-C₁₂-alkyl and/or C₁-C₈-alkoxy; and
**R₄₃** is C₁-C₈-alkyl, phenyl-C₁-C₃-alkyl, CH₂CH₂-COO(C₁-C₈-alkyl), CH₂CH₂CN, CH₂CH₂-COO(CH₂CH₂O)ₒ-H or

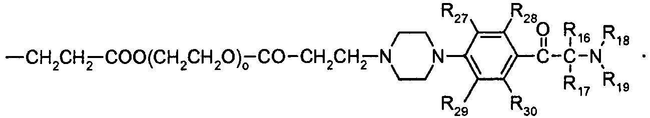

In preferred compounds of the formula III as component (a2)
**Ar₁** is an aromatic radical of formula V or VIII, as defined above;
**U** is N(R₃₂);
**V** has one of the meanings given for U or is a direct bond;
**R₁₆** and **R₁₇** are each independently of each other C₁-C₁₂-alkyl which is unsubstituted or substituted by OH, C₁-C₄-alkoxy or SH;
or R₁₆ and R₁₇ are phenyl which is unsubstituted or substituted by C₁-C₁₂-alkyl; or R₁₆ and R₁₇ are 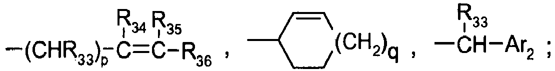 or R₁₆ and R₁₇ together are C₂-C₉-alkylene or C₃-C₉-oxaalkylene;
**p** is 1;
**q** is 0 or 1;
**Ar₂** is phenyl which is unsubstituted or substituted by halogen, OH, C₁-C₁₂-alkyl, C₁-C₁₂-alkoxy, (OCH₂CH₂)ₓOH, (OCH₂CH₂)ₓOCH₃; or the phenyl is substituted by C₁-C₄-alkyl, which is substituted by OH, halogen, C₁-C₁₂-alkoxy, (CO)O(C₁-C₄-alkyl), CO(OCH₂CH₂)ₓOCH₃ and/or OCO(C₁-C₄-alkyl);
**x** is 1-5;
**R₁₈** is C₁-C₄-alkyl, or C₂-C₄-alkyl which is substituted by OH, C₁-C₄-alkoxy, CN and/or (CO)O(C₁-C₄-alkyl);
**R₁₉** is C₁-C₄-alkyl, C₃-C₅-alkenyl, phenyl-C₁-C₃-alkyl, or C₂-C₄-alkyl which is substituted by OH, C₁-C₄-alkoxy, CN and/or (CO)O(C₁-C₄-alkyl); or R₁₈ and R₁₉ together with the nitrogen atom to which they are linked, form a 5-, 6- or 7-membered ring which optionally is interrupted by O or S;
**R₂₆, R₂₇, R₂₈, R₂₉** and **R₃₀** are each independently of one another hydrogen, halogen, C₁-C₁₂--alkyl, phenyl, benzyl, benzoyl, OR₃₂, SR₃₇, N(R₃₈)(R₃₉) or 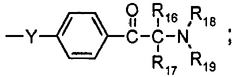 **Y** is O, S, N(R₄₀), N(R₄₀)-R₄₁-N(R₄₀) or 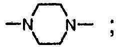 **R₃₂** is hydrogen, C₁-C₁₂-alkyl, C₃-C₆-alkenyl, or C₂-C₆-alkyl which is substituted by CN, OH, COO(C₁-C₄alkyl);
**R₃₃** is hydrogen or C₁-C₄-alkyl;
**R₃₄, R₃₅** and **R₃₆** are each independently of one another hydrogen or C₁-C₄-alkyl, or R₃₄ and R₃₅ together are C₃-C₄-alkylene;
**R₃₇** is hydrogen, C₁-C₁₂-alkyl, C₃-C₆-alkenyl, or C₂-C₁₂-alkyl which is substituted by OH, CN, or COO(C₁-C₄-alkyl);
**R₃₈** and **R₃₉** are each independently of the other C₁-C₆-alkyl, C₂-C₄-hydroxyalkyl, C₂-C₁₀-alkoxyalkyl, C₃-C₅-alkenyl, phenyl-C₁-C₃-alkyl, or phenyl which is unsubstituted or substituted by C₁-C₄-alkyl and/or C₁-C₄-alkoxy;or R₃₈ or R₃₉ are C₂-C₃alkanoyl, benzoyl or O(CO-C₁-C₈alkylene)ₒOH;
or **R₃₈** and **R₃₉** together are C₄-C₆-alkylene which optionally is interrupted by O, N(R₄₃) or S, or R₃₈ and R₃₉ together are C₄-C₆-alkylene which optionally is substituted by hydroxyl, C₁-C₄-alkoxy and/or (CO)O(C₁-C₄-alkyl);
o is an integer from 1 to15;
**R₄₀** is C₁-C₄-alkyl;
**R₄₁** is C₂-C₁₆-alkylene which optionally is interrupted by one or more O or S; and
**R₄₃** is C₁-C₄-alkyl, phenyl-C₁-C₃-alkyl, CH₂CH₂-COO(C₁-C₄-alkyl), CH₂CH₂CN, CH₂CH₂-COO(CH₂CH₂O)ₒ-H or

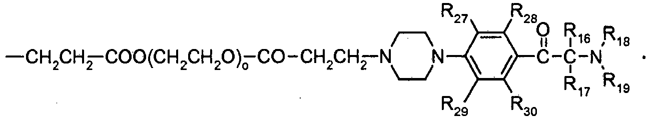

Interesting further are compounds of the formula III as defined above as component (a2), wherein
**Ar₁** is an aromatic radical of formula V, as defined above;
**R₁₆** and **R₁₇** are each independently of each other C₁-C₁₂-alkyl or 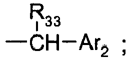 **Ar₂** is phenyl which is unsubstituted or substituted by C₁-C₁₂-alkyl;
**R₁₈** is C₁-C₄-alkyl;
**R₁₉** is C₁-C₄-alkyl;
or R₁₈ and R₁₉ together with the nitrogen atom to which they are linked form morpholino;
**R₂₆, R₂₇, R₂₈, R₂₉** and **R₃₀** are each independently of one another hydrogen or OR₃₂; and
**R₂₆, R₂₇, R₂₈, R₂₉** and **R₃₀** are each independently of one another hydrogen or OR₃₂: and
**R₃₂** is C₁-C₁₂-alkyl.

Examples of such photolatent bases (a2) are (4-morpholinobenzoyl)-1-benzyl-1-dimethylamino-propane, (4-methylthiobenzoyl)-1-methyl-1-morpholino-ethane, (3,4-dimethoxybenzoyl)-1-methyl-1-morpholino-ethane, (4-morpholinobenzoyl)-(4-methylbenzyl)-1-dimethylamino-propane, (4-(2-hydroxyethylamino)benzoyl)-1-benzyl-1-dimethylamino-propane, 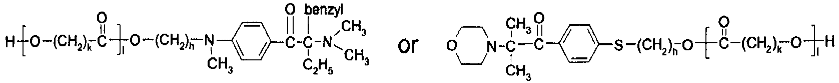 wherein I is an integer from about 1-10, k is an integer from about 2 to 10, in particular 5, h is an integer from 1 to 10, in particular 2 or 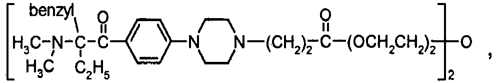 especially (3,4-dimethoxybenzoyl)-1-methyl-1-morpholino-ethane.

The preparation of photolatent base compounds is known and is for example described in WO 98/32756, WO 98/41524 and WO 03/33500. Those specifications also provide specific examples of such compounds, which hereby are incorporated by reference.

Also suitable as photolatent base donors are the α-aminoketone compounds described in EP 898 202, for example (4-morpholinobenzoyl)-1-benzyl-1-dimethylamino-propane or (4-methylthiobenzoyl)-1-methyl-1-morpholino-ethane and compounds as disclosed in WO 05/007637.

Preparation and use of photolatent bases of the formula Z3-A3 is for example disclosed in WO 97/31033.

A summary of further photobase generators is given in the form of a review by M. Shirai and M. Tsunooka in Prog. Polym. Sci., Vol. 21, 1-45 (1996). and in J. Crivello, K. Dietliker, "Photoinititiators for Free Radical Cationic & Anionic Photopolymerisation", 2nd Edition, Volume III in the Series "Chemistry & Technology of UV & EB Formulation for Coatings, Inks & Paints", John Wiley/SITA Technology Limited, London, 1998, Chapter IVI (p. 479-544).

Preferred photolatent bases in the present invention are
as component (a1) a compound 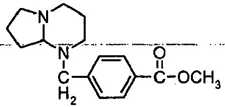 or 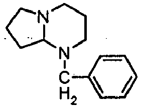 and as component (a2) the compound

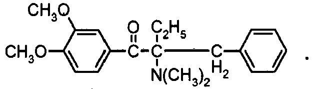

The compositions contain the photolatent base, component (a1) or (a2) or (a3), in an amount, for example, of from 0.01 to 20% by weight, preferably from 0.01 to 10% by weight, based on the total composition.

The unsaturated compounds (b) may contain one or more olefinic double bonds. They may be low molecular weight (monomeric) or higher molecular weight (oligomeric). Examples of monomers having a double bond are alkyl and hydroxyalkyl acrylates and methacrylates, e.g. methyl, ethyl, butyl, 2-ethylhexyl and 2-hydroxyethyl acrylate, isobornyl acrylate and methyl and ethyl methacrylate. Also of interest are resins modified with silicon or fluorine, e.g. silicone acrylates. Further examples are acrylonitrile, acrylamide, methacrylamide, N-substituted (meth)acrylamides, vinyl esters, such as vinyl acetate, vinyl ethers, such as isobutyl vinyl ether, styrene, alkyl- and halo-styrenes, N-vinylpyrrolidone, vinyl chloride and vinylidene chloride.

Examples of monomers having a plurality of double bonds are ethylene glycol diacrylate, 1,6-hexanediol diacrylate, propylene glycol diacrylate, dipropylene glycol diacrylate, tripropylene glycol diacrylate, neopentyl glycol diacrylate, hexamethylene glycol diacrylate and bisphenol A diacrylate, 4,4'-bis(2-acryloyloxyethoxy)diphenylpropane, trimethylolpropane triacrylate, pentaerythritol triacrylate and pentaerythritol tetraacrylate, vinyl acrylate, divinylbenzene, divinyl succinate, diallyl phthalate, triallyl phosphate, triallyl isocyanurate, tris(hydroxyethyl) isocyanurate triacrylate and tris(2-acryloylethyl) isocyanurate.

It is also possible in radiation-curable systems to use acrylic esters of alkoxylated polyols, for example glycerol ethoxylate triacrylate, glycerol propoxylate triacrylate, trimethylolpropane ethoxylate triacrylate, trimethylolpropane propoxylate triacrylate, pentaerythritol ethoxylate tetraacrylate, pentaerythritol propoxylate triacrylate, pentaerythritol propoxylate tetraacrylate, neopentyl glycol ethoxylate diacrylate or neopentyl glycol propoxylate diacrylate. The degree of alkoxylation of the polyols used may vary.

Examples of higher molecular weight (oligomeric) polyunsaturated compounds are acrylated epoxy resins, acrylated or vinyl-ether- or epoxy-group-containing polyesters, polyurethanes and polyethers. Further examples of unsaturated oligomers are unsaturated polyester resins, which are usually produced from maleic acid, phthalic acid and one or more diols and have molecular weights of from 500 to 3000. In addition it is also possible to use vinyl ether monomers and oligomers, and also maleate-terminated oligomers having polyester, polyurethane, polyether, polyvinyl ether and epoxide main chains. Combinations of vinyl-ether-group-carrying oligomers and polymers, as described in WO 90/01512, are especially suitable, but copolymers of monomers functionalised with maleic acid and vinyl ether also come into consideration. Such unsaturated oligomers can also be termed prepolymers.

Especially suitable are, for example, esters of ethylenically unsaturated carboxylic acids and polyols or polyepoxides, and polymers having ethylenically unsaturated groups in the chain or in side groups, e.g. unsaturated polyesters, polyamides and polyurethanes and copolymers thereof, alkyd resins, polybutadiene and butadiene copolymers, polyisoprene and isoprene copolymers, polymers and copolymers having (meth)acrylic groups in side chains, and also Acrylic and methacrylic acid are preferred.
Mixtures of one or more such polymers can be employed.

Preferred unsaturated polyester are for example polyester formed from diols and dicarboxylic acids with in each case at least two hydroxy or carboxy groups, respectively, as well as optionally polyols and/or polycarboxylic acids with in each case at least two hydroxy- or carboxy groups, provided that as dicarboxylic acid at least to some extend a α,ß-unsaturated dicarboxylic acid component is included. Corresponding α,ß-unsaturated dicarboxylic acid components preferably are maleic acid, fumaric acide or maleic acid anhydride, in particular maleic acid anhydride.

Examples of unsaturated carboxylic acids are acrylic acid, methacrylic acid, crotonic acid, itaconic acid, cinnamic acid and unsaturated fatty acids, such as linolenic acid and oleic acid. Oxalic acid, maleic acid, fumaric acid, succinic acid, glutaric acid, adipic acid, sebaic acid, dodecanedicarboxyilic acid, o-phthalic acid, osophthalic acid, terephthalic acid, azelaic acid, 1,4-cyclohexane dicarboxylic acid or tetrahydrophthalic acid, suberic acid, phthalic acid anhydride, tetra hydrophthalic acid anhydride, hexahydrophthalic acid anhydride, tetrachlorophthalic acid anhydride, endomethylentetrahydrophthalic acid anhydride, glutaric acid anhydride, dimeric fatty acids, their isomers and hydration products, as well as derivatives which can be esterified, such as anhydrides or dialkylester, for example C₁-C₄alkylester, especially methyl-, ethyl- or n-butylester, of the aforementioned acids. Preferred, in particular for coatings applicaitons are dicarboxylic acids of the general formula HOOC-(CH₂)_{y}-COOH, wherein y ia an integer from 1 to 20, preferably a just number from 2 to 20, in particular succinic acid, adipic acid, sebaic acid and dodecanedicarboxylic acid.
Polycarboxylic acids are for example trimellitic acid, hemimellitic acid, trimesinic acid or their ahydrides.

Suitable polyols are aromatic and especially aliphatic and cycloaliphatic polyols. Examples of aromatic polyols are hydroquinone, 4,4'-dihydroxydiphenyl, 2,2-di(4-hydroxyphenyl)propane, and novolaks and resols. Examples of polyepoxides are those based on the said polyols, especially the aromatic polyols and epichlorohydrin. Also suitable as polyols are polymers and copolymers that contain hydroxyl groups in the polymer chain or in side groups, e.g. polyvinyl alcohol and copolymers thereof or polymethacrylic acid hydroxyalkyl esters or copolymers thereof. Further suitable polyols are oligoesters having hydroxyl terminal groups.

Examples of aliphatic and cycloaliphatic polyols include alkylenediols having preferably from 2 to 12 carbon atoms, such as ethylene glycol, 1,2- or 1,3-propanediol, 1,2-, 1,3- or 1,4-butanediol, pentanediol, hexanediol, octanediol, dodecanediol, diethylene glycol, triethylene glycol, polyethylene glycols having molecular weights of preferably from 200 to 1500, 1,3-cyclopentanediol, 1,2-, 1,3- or 1,4-cyclohexanediol, 1,4-dihydroxymethylcyclohexane, glycerol, tris(β-hydroxyethyl)amine, trimethylolethane, trimethylolpropane, pentaerythritol, dipentaerythritol and sorbitol.

Examples of diols for the preparation os such polyesters are 2,2-dimethyl-1,2-ethandiol, 3-methylpentane-1,5-diol, 2-ethylhexane-1,3-diol, 2,4-diethyloctane-1,3-diol, tetraethylene-glycol, pentaethyleneglycol, neopentylglycol, 2-ethyl-1,3-propanediol, 2-methyl-1,3-propanediol, 2-ethyl-1,3-hexanediol, 2,4-diethyloctane-1,3-diol, hydroquinone, bisphenol A, bisphenol F, bisphenol B, bisphenol S, 2,2-bis(4-hydroxycyclo-hexyl)propane, 1,1-, 1,2-, 1,3- and 1,4-cyclohexanedimethanol.
Preferred, in particular in coating applications, are alcohols of the general formula HO-(CH₂)ₓ-OH, wherein x is an integer from 1 to 20, preferably an even number from 2 to 20. Preferred are ethylene glycol, butane-1,4-diol, hexane-1,6-diol, octane-1,8-diol and do-decane-1,12- diol as well as neopentylglycol.
Examples of polyols for the preparation os such polyesters are trimethylolbutane, trimethylolpropane, trimethylolethane, pentaerythrite, glycerine, ditrimethylolpropane, dipentaerythrit, sorbite, mannite, diglycerol, threite, erythrite, adonite (ribite), arabite (lyxite), xylite, dulcite (galactite), maltite and isomalte.
Further suitable are polyesterdiols based on lactones, such as homo polymerisates or mixed polymerisates of lactones, preferably products of lactones and suitable difunctional starter molecules, which products have terminal hydroxyl groups. Preferred lactones are compounds derived from the general formula HO-(CH₂)_{Z}-COOH, wherein z is an integer from 1 to 20 and a H-atom of a methylene component optionally is substituted by C₁-C₄-alkyl, Examples are ε-caprolactone, ß-propiolactone, γ-butyrolactone and/or methyl-ε-caprolactone, 4-hydroxybenzoic acid, 6-hydroxy-2-naphthalic acid or pivalolactone as well as mixtures thereof. Suitable starter components are for example the above as building components for polyester polyols mentioned low molecular divalent alcohols. Corresponding polymerisates of e-caprolactone are preferred, in particular for coatings applications. Further low molecular polyesterdiols or polyetherdiols may be used as starter fort he preparation of the lacton-polymerisates. Instead of the polymerisates of lactone also the corresponding chemically equivalent polycondensates of the respective hydroxycarboxylic acids may be used.
The polyols may be partially or fully esterified by one or by different unsaturated carboxylic acid(s), it being possible for the free hydroxyl groups in partial esters to be modified, for example etherified, or esterified by other carboxylic acids.

Examples of esters are:
trimethylolpropane triacrylate, trimethylolethane triacrylate, trimethylolpropane trimethacrylate, trimethylolethane trimethacrylate, tetramethylene glycol dimethacrylate, triethylene glycol dimethacrylate, tetraethylene glycol diacrylate, pentaerythritol diacrylate, pentaerythritol triacrylate, pentaerythritol tetraacrylate, dipentaerythritol diacrylate, dipentaerythritol triacrylate, dipentaerythritol tetraacrylate, dipentaerythritol pentaacrylate, dipentaerythritol hexaacrylate, tripentaerythritol octaacrylate, pentaerythritol dimethacrylate, pentaerythritol trimethacrylate, dipentaerythritol dimethacrylate, dipentaerythritol tetramethacrylate, tripentaerythritol octamethacrylate, pentaerythritol diitaconate, dipentaerythritol trisitaconate, dipentaerythritol pentaitaconate, dipentaerythritol hexaitaconate, ethylene glycol diacrylate, 1,3-butanediol diacrylate, 1,3-butanediol dimethacrylate, 1,4-butanediol diitaconate, sorbitol triacrylate, sorbitol tetraacrylate, pentaerythritol-modified triacrylate, sorbitol tetramethacrylate, sorbitol pentaacrylate, sorbitol hexaacrylate, oligoester acrylates and methacrylates, glycerol di- and triacrylate, 1,4-cyclohexane diacrylate, bisacrylates and bismethacrylates of polyethylene glycol having a molecular weight of from 200 to 1500, and mixtures thereof.

Examples of (meth)acrylate compounds, in particular for coatings applications, are (meth)acrylic acid esters and in particular acrylic acid esters of polyfunctional alcohols, preferably such, which do not comprise any further functional groups besides the hydroxyl groups or, if any ether groups. Examples are bifunctional alcohols, such as ethylene glycol, propylene glycol and corresponding higher condensed compounds, e.g. diethylene glycol, triethylene glycol, dipropylene glycol, tripropylene glycol etc., 1,2-, 1,3- or 1,4-butanediol, 1,5-pentanediol, 1,6-hexanediol, 3-methyl-1,5-pentanediol, neopentylglycol, alkoxylated phenolic compounds, such as ethoxylated or propoxylated bisphenols, 1,2-, 1,3- or 1,4-cyclohexanedimethanol, trifunctional and higher functional alcohols, such as glycerine, trimethylolpropane, butanetriol, trimethylolethane, pentaerythrite, ditrimethylolpropane, dipentaerythrite, sorbite, mannite and the corresponding alkoxylated, preferably ethoxylated and/or propoxylated alcohols, as well as poly-tetrahydrofurane with a molecular weight between from 162 and 2000, poly-1,3-propanediol with a molecular weight between from 134 and 2000 or polyethyleneglycol with a molecular weight between from 238 and 2000.

Suitable unsaturated polyesters and polyamides are derived, for example, from maleic acid and diols or diamines. The maleic acid may have been partially replaced by other dicarboxylic acids. They may be used together with ethylenically unsaturated comonomers, e.g. styrene. The polyesters and polyamides may also be derived from dicarboxylic acids and ethylenically unsaturated diols or diamines, especially from those having longer chains of e.g. from 6 to 20 carbon atoms.

Examples of polyurethanes are those composed of saturated diisocyanates and unsaturated diols or unsaturated diisocyanates and saturated diols.
Suitable are urethane acrylates, which generally are addition products of multifunctional isocyanates, like toluene diisocyanates, hexamethylene diisocyanates, isophorone diisocyanates or their condensation products, e.g. isocyanurates, biurets, with polyols and hydroxyalkyl acrylates, for instance hydroxyethyl acrylate, hydroxybutyl acrylate or pentaerythritol triacrylate.
Examples of customary diisocyanates are aliphatic diisocyanates such as tetramethylene diisocyanate, hexamethylene diisocyanate (1,6-diisocyanato hexane), octamethylene diisocyanate, decamethylene diisocyanate, dodecamethylene diisocyanate, tetradecamethylene diisocyanate, derivatives of lysine diisocyanates, tetramethylxylylene diisocyanate, trimethylhexane diisocyanate or tetramethylhexane diisocyanate, cycloaliphatic diisocyanates, like 1,4-, 1,3- or 1,2- diisocyanatocyclohexane, 4,4'- or 2,4'-di(isocyanatocyclohexyl)methane, 1-isocyanato-3,3,5-trimethyl-5-(isocyanatomethyl)cyclohexane (isophoronediisocyanate), 1,3-or 1,4-bis(isocyanatomethyl)cyclohexane, or 2,4- or 2,6-diisocyanato-1-methylcyclohexane as well as aromatic diisocyanates like 2,4- or 2,6-toluylene diisocyanate and corresponding isomeric mixtures, m-or p-xylylene diisocyanate, 2, 4'- or 4,4'-diisocyanatodiphenyl methane and corresponding isomeric mixtures, 1, 3- or 1,4-phenylene diisocyanates, 1-chloro-2,4-phenylene diisocyanates, 1,5-naphthylene diisocyanate, diphenylene-4,4'-diisocyanate, 4,4'-diisocyanato-3,3'-dimethyldiphenyl, 3-methyldiphenylmethane-4,4'-diisocyanate, tetramethylxylylene diisocyanate, 1,4-diisocyanato benzene or diphenylether-4,4'-diisocyanate. It is evident, that the compositions also may comprise mixtures of diisocyanates.
Preferred are hexamethylene diisocyanate, 1,3-bis(isocyanatomethyl)cyclohexane, isophorone diisocyanate and di(isocyanatocyclohexyl)methane, in particular hexamethylene diisocyanate.
Interesting are polyisocyanates of aromatic, aliphatic and/or cycloaliphatic diisocyanates, in particular aliphatic and/or cycloaliphatic isocyanato-isocyanurates for example those based on hexamethylene diisocyanate and isophorone diisocyanate. Commonly said isocyanato-isocyanurates for example have a content of NCO of 10-30 weight-%, in particular 15-25 weight-% and an average NCO-functionality of 3-4.5.
Of interest further are polyisocyanates comprising biuret groups with aromatic, cycloapliphatic or aliphatic bound isocyanate groups, in particular tris(6.isocyanatohexyl) biuret or mixtures with its higher homologes. Said polyiisocyanates comprising biuret groups usually for example have a content of NCO of 18-25 weight-% and an average NCO-functionality of 3-4.5.
Other interesting polyisocyanates with aromatic, cycloapliphatic or aliphatic, in particular aliphatic or cycloaliphatic, bound isocyanate groups, are such comprising urethane or/and allophanate groups, which are for example obtained by reaction of hexamethylene diisocyanate or isophorone diisocyante (in excess) with polyvalent alcohols such as trimethylol propane, neopentyl glycol, pentaerythrit, 1,4-butanediol, 1,6-hexanediol, 1,3-propaned iol, ethyleneglycol, diethylene glycol, glycerine,1,2-dihydroxypropane or mixtures thereof. Said polyisocyanates comprising urethane or/and allophanate groups usually for example have a content of NCO of 12-2o weight-% and an average NCO-functionality of at least 2.

Suitable polyols and hydroxyalkyl acrylates as condensation partners for the isocyanates described above are for example such as given above in the connection with the description of acrylates and carboxylic acid esters.

Further examples for suitable isocyante components are for example disclosed in WO 2006/092434 (see in particular page 17 ff.)

Polybutadiene and polyisoprene and copolymers thereof are known. Suitable comonomers include, for example, olefins, such as ethylene, propene, butene and hexene, (meth)acrylates, acrylonitrile, styrene and vinyl chloride. Polymers having (meth)acrylate groups in the side chain are likewise known. Examples are reaction products of novolak-based epoxy resins with (meth)acrylic acid; homo- or co-polymers of vinyl alcohol or hydroxyalkyl derivatives thereof that have been esterified with (meth)acrylic acid; and homo- and co-polymers of (meth)acrylates that have been esterified with hydroxyalkyl (meth)acrylates. (The term "(meth)acrylate" in the context of this Application denotes both "acrylate" and "methacrylate".)

Suitable components (b) are also acrylates that have been modified by reaction with primary or secondary amines, as described e.g. by Gaske in US 3 844 916, by Weiss et al. in EP 280 222, by Meixner et al. in US 5 482 649 or by Reich et al. in US 5 734 002. Such amine-modified acrylates are also known as aminoacrylates. Aminoacrylates are obtainable e.g. from UCB Chemicals under the name EBECRYL 80, EBECRYL 81, EBECRYL 83, EBECRYL 7100, from BASF under the name Laromer PO 83F, Laromer PO 84F, Laromer PO 94F, from Cognis under the name PHOTOMER 4775 F, PHOTOMER 4967 F or from Cray Valley under the name CN501, CN503, CN550.
The polymerisable compounds can be used on their own or in any desired mixtures. Preferably mixtures of polyol (meth)acrylates are used.

Preferably, in particular if the composition is used in coatings applications, the component (b) comprises at least one compound with at least one ethylenically α,β-unsaturated carbonyl component. Such compounds especially are unsaturated polyester or (meth)acrylate compounds, in particular (meth)acrylate compounds, preferably acrylate compounds, that is derivates of acryl ic acid. The unsaturated polyester and (meth)acrylate compounds for example comprise more than 2, preferably 2 to 20, especially 2 to 10 or in particular 2 to 6 radically polymerisable, α,ß-ethylenically unsaturated carbonyl groups.
Said compounds with at least two radically polymerisable groups for example can be used in combination with reactive diluents, compounds with a radically polymerisable group. Preferred are compounds with a content of ethylenically unsaturated double bonds from 0.1 to 0.7 mol/100 g, in particular 0.2 to 0.6 mol/100 g.
The average number molecular weight Mₙ of the compounds is for example below 15000, or from 300 to 12000, especially 400 to 5000, in particular from 500 to 3000 g/mol (determined by gel permeation chromatography with polystyrene as standard and tetrahydrofurane as eluant).

Examples of suitable Polyesters, dicarboxylic acids, polycarboxylic acids, polyols and diols are given above.

The products of the alkoxylation are available through known methods by reactingthe abovementioned alcohols with alkylene oxides, in particular ethylene oxide or propylene oxide. Preferably the grade of alkoxylation per hydroxyl group is from 0 to 10, that is 1 mol hydroxyl group may be alkoxylated with to about 10 mol alkylene oxides. Further (meth)acrylate compounds are polyester(meth)acrylates, for example the (meth)acrylic acid ester of polyesterols, as well as urethane-, epoxy-, polyether-, silicone-, carbonate- or melamine(meth)acrylates.
In particular preferred in coatings at least one component is a urethane- or polyester(meth)-acrylate, especially at least one urethane(meth)acrylate.
Urethane(meth)acrylates for example are available by reaction of polyisocyanates with hydroxyalkyl(meth)acrylates and optionally compounds for chain prolongation, such as dio- ls, polyols, diamines, polyamines, dithiols or polythiols. Said uethane(meth)acrylates preferably have a number average molecular weight Mₙ from 500 to 20 000, for example from 750 to 10 000, preferably from 750 to 3000 g/mol (determined by gel permeation chromatography with polystyrene as standard). The urethane(meth)acrylates for example have a content from about 1 to 5, preferably from 2 to 4, Mol (meth)acryl groups per 1000 g urethane(meth)acrylate.
Epoxy(meth)acrylates are for example available by reaction of epoxides with (meth)acrylic acid. Suitable epoxides are for example epoxidised olefines or glycidylethers, e.g. bisphenol-A-diglycidylether or aliphatic glycidylether, such as butanedioldiglycidether. Melamin(meth)acrylates are for example available by reation of melamine with (meth)acrylic acid or corresponding esters.
The epoxy(meth)acrylates and melamin(meth)acrylates for example have a number average molecular weight Mₙ from 500 to 20000, for example from 750 to 10000 g/mol preferably from 750 to 3000 g/mol; the content of (meth)acryl groups is for example 1 to 5, preferably 2 to 4 per 1000 g epoxy(meth)acrylate or melamine(meth)acrylate mol (determined by gel permeation chromatography with polystyrene as standard and tetrahydrofurane as eluant).
Further suitable, in particular in coatings applications, are carbonate(meth)acrylates, in average comprising for example 1 to 5, especially 2 to 4, preferably 2 to 3, in particular 2 (meth)acryl groups. The number average molecular weight Mₙ of said carbonate(meth)-acrylates is for example lower than 3000 g/mol, especially lower than 1500 g/mol, preferably lower than 800 g/mol (determined by gel permeation chromatography with polystyrene as standard and tetrahydrofurane as eluant). Carbonate(meth)acrylates are for example available by reaction of carbonic acid esters with polyvalent, in particular divalent alcohols (diols, e.g. hexanediol) followed by esterification of the free OH-groups with (meth)acrylic acid or transesterification with (meth)acrylic acid esters,as for example described in EP92269. said compounds are also available by reaction with phosgene, derivatives of urea with polyvalent, e.g. divalent, alcohols.
Examples of reactive diluents are radiation curable, radically or cationically polymerisable compounds with one ethylenically unsaturated, copolymerisable group. For example C₁-C₂₀-alkyl(meth)acrylates, vinylaromats with up to 20 C-atoms, vinylesters of carbonic acids with up to 20 C-atom, ethylenically unsaturated nitriles, vinylethers of alcohols with 1 to 10 C-atoms, α,ß-unsaturated carbonic acids and their anhydrides and aliphatic hydrocarbons with 2 to 8 C-atoms and 1 or 2 double bonds.
Preferred, in particular in coating applications are (meth)acrylic acid alkylester with C₁-C₁₀-alkyl, such as methylmethacrylate, methylacrylate, n-butylacrylate, ethylacrylate and 2-ethylhexylacrylate. Suitable in particular are mixtures of (meth)acrylic acid alkylesters. Examples of vinylesters of carbonic acids with 1 to 20 C-atoms are vinyllaurate, vinylstearate, vinylpropionate and vinylacetate. Examples of α,ß-unsaturated carbonic acids and their anhydrides are acrylic acid, methacrylic acid, fumaric acid, crotonic acid, itaconic acid, maleic acid or maleiic acid anhydrid, preferably acrylic acid. Examples of vinylaromatic compounds are vinyltoluene, α-butylstyrene, 4-n-butylstyrene, 4-n-decylstyrene and preferably styrene. Examples of nitriles are acrylnitrile and methacrylnitrile. Suitable vinylethers are e.g. vinylmethylether, vinylisobutylether, vinylhexylether and vinyloctylether. Examples of nonaromatic hydrocarbons with 2 to 8 C-atoms and one or two olefinic double bonds are butadiene, isoprene, as well as ethylene, propylene and isobutylene. Suitable also are N-vinylformamide, N-vinylpyrrolidone and N-vinylcaprolactame.

Binders may also be added to the compositions according to the invention, this being particularly advantageous when the polymerisable compounds are liquid or viscous substances. The amount of binder may be, for example, from 5 to 95 % by weight, preferably from 10 to 90 % by weight and especially from 40 to 90 % by weight, based on total solids. The choice of binder is made in accordance with the field of use and the properties required therefor, such as developability in aqueous and organic solvent systems, adhesion to substrates and sensitivity to oxygen.
Suitable binders are, for example, polymers having a molecular weight of from 5000 to 2 000 000, preferably from 10 000 to 1 000 000. Examples are: homo- and co-polymers of acrylates and methacrylates, e.g. copolymers of methyl methacrylate/ethyl acrylate/- methacrylic acid, poly(methacrylic acid alkyl esters), poly(acrylic acid alkyl esters); cellulose esters and ethers, such as cellulose acetate, cellulose acetate butyrate, methylcellulose, ethylcellulose; polyvinylbutyral, polyvinylformal, cyclised rubber, polyethers, such as polyethylene oxide, polypropylene oxide, polytetrahydrofuran; polystyrene, polycarbonate, polyurethane, chlorinated polyolefins, polyvinyl chloride, copolymers of vinyl chloride/vinylidene chloride, copolymers of vinylidene chloride with acrylonitrile, methyl methacrylate and vinyl acetate, polyvinyl acetate, copoly(ethylene/vinyl acetate), polymers such as polycaprolactam and poly(hexamethylene adipamide), polyesters such as poly(ethylene glycol terephthalate) and poly(hexamethylene glycol succinate).

The unsaturated compounds can also be used in admixture with, for example, physically drying polymers or solutions thereof in organic solvents, for example nitrocellulose or cellulose acetobutyrate, but they may also be chemically or thermally curable resins, for example polyisocyanates, polyepoxides or melamine resins.

Finally, the radically polymerizable material could also be any thermoplastic or rubbery compound, e.g. polyolefins, EPDM and the like, which are usually crosslinked by peroxides. This peroxide crosslinking is well-known and practised in a variety of applications, including insulating material of electrical cables, highly cross-linked polyolefin tubes or pipes as those used for water-circulation heating for example, crosslinked polyolefin foams.
Electric cables, and particularly electric power cables for medium and high voltages, are usually composed of a plurality of polymer layers extruded around the electric conductor. In power cables the electric conductor is usually coated first with an inner semiconductor layer followed by an insulating layer, then an outer semiconductor layer possibly followed by water barrier layers, and on the outside a sheath layer. The layers of the cable are made of various polyolefin plastics, usually crosslinked polyethylene. Polyolefin plastics may be composed of homopolymers or copolymers of ethylene, wherein the copolymers may be graft copolymers or co- polymers of ethylene and one or more monomers which are copolymerisable with ethylene. LDPE (low density polyethylene, i. e. polyethylene prepared by radical polymerisation at a high pressure) crosslinked with peroxide, for instance dicumyl peroxide, in connection with the extrusion of cable, is today the predominant cable insulating material. The redox mechanism described in the invention, which results in the generation of radicals from the activation of an organic peroxide by an amine that is generated by a pholtolatent amine upon exposure to UV light, can therefore be used to promote or/and enhance the crosslinking of a thermoplastic polymer, e.g. polyolefins, at a desired moment in a production process, e.g. extrusion process, through the use of UV irradiation. This "cure-on-demand" process, which consists in the release of the active ingredient at a selected moment by means of UV irradiation, can lead to a better control of the crosslinking process in the production of highly-crosslinked materials.

A a free radical initiator capable to be reduced by amines and/or amidines (c) is for example a compound which comprises at least one peroxy group (-O-O-).
These are for example i) peroxidic salts, ii) hydrogen peroxide (H₂O₂), iii) hydroperoxides, that is compounds which comprise at least one hydroperoxide group (-O-O-H), or iv) peroxides, that is compounds which are substituted by organi groups at both valencies of the peroxy radical (-O-O-). Examples thereof are given in *"*Polymer Handbook ed. 1999, Wiley & Sons, New York", the corresponding disclosure thereof hereby is incorporated by reference.

Compounds i) are for example peroxodisulfates, e.g. potassium peroxodisulfate, sodium peroxodisulfate or ammonium peroxodisulfate, etc.; peroxides, such as for example sodium peroxide or potassium peroxide, etc., perborates, such as for example ammonium perborate, sodium perborate or potassium perborate, etc., monopersulfates, such as for example ammonium hydrogenmonopersulfate, sodium hydrogenmonopersulfate or potassium hydrogenmonopersulfate, etc., as well as salts of the peroxy carboxylic acids which are cited under item iv), e.g. ammonium monoperoxyphthalate, sodium monoperoxyphthalate, potassium monoperoxyphthalate or magnesium monoperoxyphthalate.

ii) for example is hydrogenperoxide, for example as aqueous solution in a concentration of for example 10% to 50% by weight.

Examples of compounds iii) are tert. butylhydroperoxide, tert. amylhydroperoxide, cumylhy-droperoxide, toluyl hydroperoxide, p-bromobenzoyl hydroperoxidepinane hydroperoxide, diisopropylbenzene hydroperoxide1-cyclohexanol-1-hydroperoxide, peracetic acid, perbenzoic acid, monoperphthalic acid or meta-chloroperbenzoic acid, etc..

Compounds iv) are for example ketoperoxides, dialkylperoxides, diacylperoxides or mixed acyl-alkylperoxides. Examples of diacylperoxides are dibenzoyl peroxide and diacetyl peroxide, etc.. Examples of dialkylperoxides are di-tert-butyl peroxide, di-cumyl peroxide, bis-(α,α-dimethylbenzyl)peroxide and diethyl peroxide.
A mixed acyl-alkylperoxide is for example tert. butylperbenzoic acid ester. Ketoperoxides are for example acetone peroxide, butanone peroxide, 1,1'-peroxy-bis-cyclohexanol, methyl ethyl ketone peroxide and anisoyl peroxide.
Others are for example 1,2,4-trioxolane or 9,10-dihydro-9,10-epidioxidoanthracene.

Preferred are the compounds i), iii) and iv), especially iii) and iv), in particular iv). Diacylperoxides, dialkylperoxides and ketoperoxides are especially preferred, for example diacylperoxides and dialkylperoxides, in particular diacylperoxides.
Especially preferred are dibenzoylperoxide and methyl ethyl ketone peroxide.

The compounds i)-)iv) in most cases are solid and can for example be mixed into the composition in solid form, as solution or suspended in a suitable solvent. Preferably a solution or suspension, in partiuclar a solution, e.g. in a component of (b) is used.

Further suitable as a free radical initiator capable to be reduced by amines and/or amidines, that is component (c) of the composition according to the invention are for example N-oxyl compounds such as 4-hydroxy-2,2,6,6-tetramethylpiperidine-N-oxyl, 4-amino-2,2,6,6-tetramethyl-piperidine-N-oxyl or 3-hydroxy-2,2,5,5-tetramethyl-pyrrolidine-N-oxyl. Other examples for component (c) are thermal initiators, such as hydroxylamine esters, for example comprising a structural element of formula (XX) or (XX'): 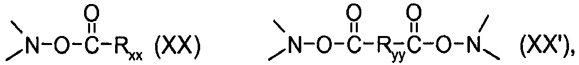 wherein
**Rₓₓ** is for example hydrogen, C₁-C₃₆alkyl, C₂-C₃₆alkenyl, C₂-C₁₈alkinyl, C₆-C₁₀aryl, -O-C₁-C₁₈alkyl, -O-C₆-C₁₀aryl, -NH-C₁-C₁₈alkyl, -NH-C₆-C₁₀aryl, -N(C₁-C₆alkyl)₂;
**R_{yy}** is for example a direct bond, C₁-C₃₆alkylene, C₂-C₃₆alkenylene, C₂-C₃₆alkinylene, -(C₁-C₆alkylene)-phenyl-(C₁-C₆alkylene)- or a group 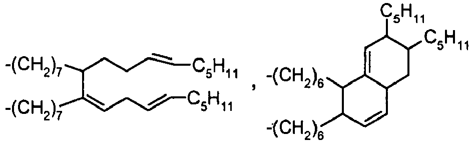 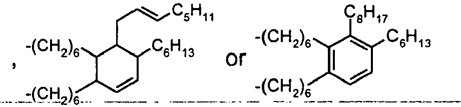 or polymeric hydroxylamine esterss of the formula (YY) or (YY') 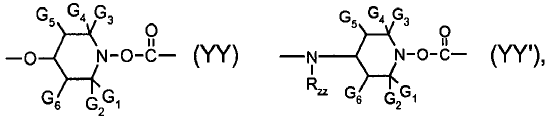 wherein
**G₁, G₂, G₃** and **G₄** independently of each other are C₁-C₄alkyl or G₁ and G₂ together and G₃ and G₄ together are pentamethylene;
**G₅** and **G₆** independently of one another hydrogen or C₁-C₄alkyl; and
**R_{zz}** is C₁-C₁₂alkyl, C₅-C₇cycloalkyl, benzyl or phenylethyl, C₂-C₁₈alkanoyl, C₃-C₅alkenoyl or benzoyl.

Such compounds are for example disclosed in WO 2004/081100. In particular preferred are the compounds of formula (A), (B), (C), (D), (E), (F), (G), (H), (I), (K), (L), (M), (N), (O), (P), (Q), (R) and (S) as defined in WO 2004/081100. Specific examples of such compounds are compounds Nos. 101-160 as disclosed in table 1 of WO 2004/081100.

Component (c) usually is present in the composition of the present invention in an amount from 0.001 to 20%, preferably from 0.1 to 10 %, based on the weight of the composition.

Subject of the invention further is a composition according to claim 1, additionally to components (a1) or (a2) or (a3), (b) and (c) comprising
(d) an initiator which is capable of curing (b), in particular a radical photoinitiator.

As initiator (d) which is capable of curing (b), for example radical photoinitiators known in the art are employed.

Examples are compounds of the benzophenone type; acetophenone, compounds, such as for exmaple α-hydroxy ketones or α-amino ketones; 4-aroyl-1,3-dioxolanes; benzoin alkyl ethers and benzil ketals; phenylglyoxalic esters and derivatives thereof; oxime esters; peresters; monoacyl phosphine oxides; bisacylphosphine oxides; trisacylphosphine oxides; halomethyltriazines; hexaarylbisimidazole / coinitiators systems; ferrocenium compounds; or titanocenes, as well as borate compounds which can be used as coinitiators.
Such compounds are known to the person skilled in the art and disclosed in a host of publications and patents. Reviews are given for example by J.V. Crivello and K. Dietliker in "Chemistry & Technology of UV & EB Formulation for Coatings, Inks & Paints, Vol. III, Photoinitiators for Free Radical Cationic & Anionic Photopolymerisation", 2nded., Wiley&Sons, 1998 and by K. Dietliker in "A Compilation of Photoinitiators commercially available for UV today"Sita Technology Ltd., 2002*.*

Accordingly, component (d) of the present invention for example is a compound of the formula (1), (2), (3), (4), (5) or (6): 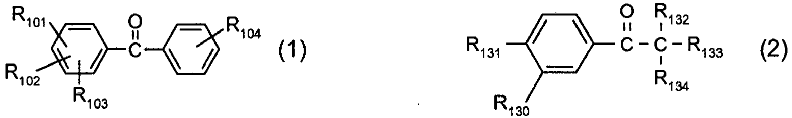 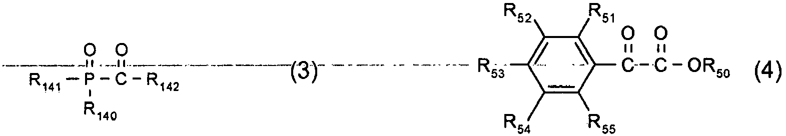 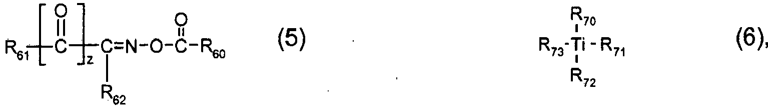 wherein **R₁₀₁, R₁₀₂** and **R₁₀₃** independently of one another are hydrogen, C₁-C₄-alkyl, C₁-C₄-halogenalkyl, C₁-C₄-alkoxy, C₁-C₄thioalkyl, halogen or N(C₁-C₄-alkyl)₂;
**R₁₀₄** has one of the meanings as given for R₁₀₁, R₁₀₂ and R₁₀₃ or is phenyl, COOCH₃, 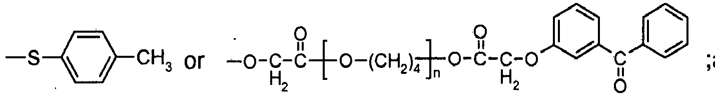 and
**n** is 2-10;
**R₁₃₀** is hydrogen or C₁-C₁₈-alkoxy;
**R₁₃₁** is hydrogen, C₁-C₁₈-alkyl, C₁-C₁₂hydroxyalkyl ,C₁-C₁₈-alkoxy, -OCH₂CH₂-OR₁₃₅, morpholino, C₁-C₁ₛalkyl-S-, a group H₂C=CH-, H₂C=C(CH₃)- , 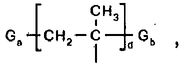 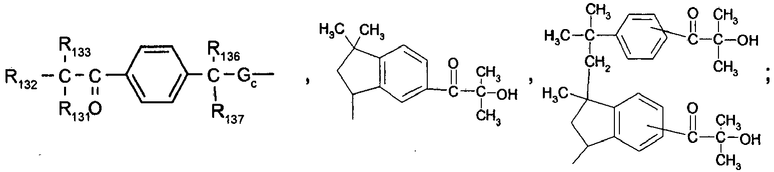 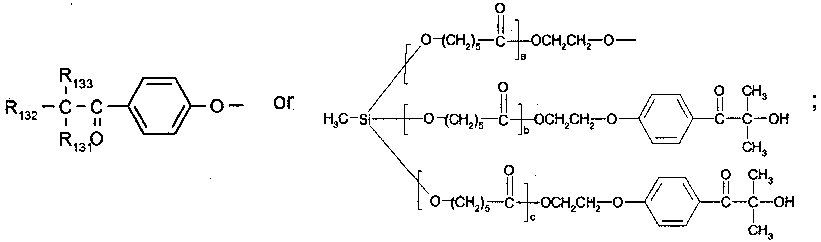 **R₁₃₂** is hydroxy, C₁-C₁₆-alkoxy, morpholino, dimethylamino or -O(CH₂CH₂O)ₑ-C₁-C₁₆-alkyl;
**R₁₃₃** and **R₁₃₄** independently of one another are hydrogen, C₁-C₆-alkyl, C₁-C₁₆-alkoxy or -O(CH₂CH₂O)ₑ-C₁-C₁₆-alkyl; or unsubstituted phenyl or benzyl; or phenyl or benzyl substituted by C₁-C₁₂-alkyl; or R₁₃₃ and R₁₃₄ together with the carbon atom to which they are attached form a cyclohexyl ring;
with the proviso that R₁₃₂, R₁₃₃ and R₁₃₄ not all together are C₁-C₁₆-alkoxy or -O(CH₂CH₂O)ₑ-C₁-C₁₆-alkyl;
**R₁₃₅** is hydrogen, 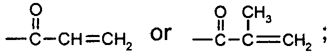 **R₁₃₆** and **R₁₃₇** independently of one another are hydrogen, C₁-C₁₂alkyl, C₁-C₁₂alkoxy or OH; **Gₐ** and **G_{b}** independently of one another are end groups of the polymeric structure, preferably hydrogen or methyl;
**G_{c}** is a direct bond, O or S;
**a, b** and **c** are 1-3;
**d** is 2-10; and
**e** is 1-20;
**R₁₄₀** and **R₁₄₁** independently of one another are linear, branched or cyclic C₁-C₂₀-alkyl; phenyl, naphthyl or biphenylyl; all of which are unsubstituted or substituted by halogen, C₁-C₁₂-alkyl, C₁-C₁₂-alkoxy, C₁-C₁₂alkylthio or NR₁₄₃R₁₄₄, or R₁₄₀ and R₁₄₁ are independently of one another -(CO)R₁₄₂;
**R₁₄₂** is cyclohexyl, cyclopentyl, phenyl, naphthyl, biphenylyl or a 5- or 6-membered heterocyclic ring with a S-atom or N-atom; all of which are unsubstituted or substituted by one or more halogen, C₁-C₄-alkyl and/or C₁-C₄-alkoxy;
**R₁₄₃** and **R₁₄₄** independently of one another are hydrogen, unsubstituted C₁-C₁₂-alkyl or C₁-C₁₂-alkyl substituted by OH or SH wherein the alkyl chain optionally is interrupted by one to four oxygen atoms; or R₁₄₃ and R₁₄₄ independently of one another are C₂-C₁₂-alkenyl, cyclopentyl, cyclohexyl, benzyl or phenyl;
**R₅₀** is hydrogen, C₁-C₁₂-alkyl or 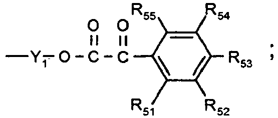 **R₅₁, R₅₂**, **R₅₃, R₅₄** and **R₅₅** independently of one another are hydrogen; unsubstituted C₁-C₁₂-alkyl or C₁-C₁₂-alkyl substituted by OH, C₁-C₄-alkoxy, C₁-C₄-alkylthio, phenyl, naphthyl, halogen or CN; wherein the alkyl chain optionally is interrupted by one or more oxygen atoms; or R₅₁, R₅₂, R₅₃, R₅₄ and R₅₅ independently of one another are C₁-C₄-alkoxy, C₁-C₄-alkythio or NR₅₆R₅7;
**R₅₆** and **R₅₇** independently of one another are hydrogen, unsubstituted C₁-C₁₂-alkyl or C₁-C₁₂-alkyl substituted by OH or SH wherein the alkyl chain optionally is interrupted by one to four oxygen atoms; or R₅₆ and R₅₇ independently of one another are C₂-C₁₂-alkenyl, cyclopentyl, cyclohexyl, benzyl or phenyl; and
**Y₁** is C₁-C₁₂-alkylene optionally interrupted by one or more oxygen atoms;
**z** is 0 or 1;
**R₆₀** is hydrogen, C₃-C₈cycloalkyl; C₁-C₁₂alkyl which is unsubstituted or substituted by one or more halogen, phenyl and/or CN; or R₆₀ is C₂-C₅alkenyl; phenyl which is unsubstituted or substituted by one or more C₁-C₆alkyl, halogen, CN, OR₆₃, SR₆₄ and/or NR₆₅R₆₆; or R₆₀ is C₁-C₈alkoxy, benzyloxy; or phenoxy which is unsubstituted or substituted by one or more C₁-C₆alkyl and/or halogen;
R₆₁ is phenyl, naphthyl, benzoyl or naphthoyl, each of which optionally is substituted 1 to 7 times by halogen, C₁-C₁₂alkyl, C₃-C₈cycloalkyl, benzyl, phenoxycarbonyl, C₂-C₁₂alkoxycarbonyl, OR₆₃, SR₆₄, SOR₆₄, SO₂R₆₄ and/or NR₆₅R₆₆, wherein the substituents OR₆₃, SR₆₄ and NR₆₅R₆₆ optionally form 5- or 6-membered rings *via* the radicals R₆₃, R₆₄, R₆₅ and/or R₆₆ with further substituents on the phenyl or naphthyl ring;

Or each of which is substituted by phenyl or by phenyl which is substituted by one or more OR₆₃, SR₆₄ and/or NR₆₅R₆₆;
or R₆₁ is thioxanthyl or 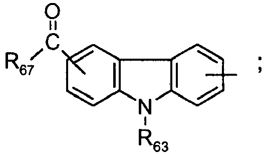 **R₆₂** is hydrogen; unsubstituted C₁-C₂₀alkyl or C₁-C₂₀alkyl substituted by one or more halogen, OR₆₃ or phenyl; or is C₃-C₈cycloalkyl; phenyl which is unsubstituted or substituted by one or more C₁-C₆alkyl, phenyl, halogen, OR₆₃, SR₆₄ and/or NR₆₅R₆₆; or is C₂-C₂₀alkanoyl or benzoyl which is unsubstituted or substituted by one or more C₁-C₆alkyl, phenyl, OR₆₃, SR₆₄ and/or NR₆₅R₆₆; or is C₂-C₁₂alkoxycarbonyl, phenoxycarbonyl, CN, CONR₆₅R₆₆, NO₂, C₁-C₄haloalkyl, S(O)ₛ-C₁-C₆alkyl; S(O)ₛ-phenyl;
**s** is 1 or 2;
**R₆₃** and **R₆₄** independently of one another are hydrogen, C₁-C₂₀alkyl, C₂-C₁₂alkenyl, C₃-C₈cycloalkyl, phenyl-C₁-C₃alkyl; or are C₁-C₈alkyl which is substituted by 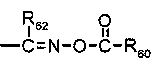 , OH, SH, CN, C₁-C₈alkanoyl; or are benzoyl, which is unsubstituted or substituted by one or more C₁-C₆alkyl, halogen, OH, C₁-C₄alkoxy, C₁-C₄alkylsulfanyl or 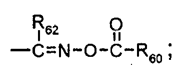 ; or are phenyl or naphthyl, each of which is unsubstituted or substituted by halogen, C₁-C₁₂alkyl, C₁-C₁₂alkoxy, phenyl-C₁-C₃alkyloxy, phenoxy, C₁-C₁₂alkylsulfanyl, phenylsulfanyl, N(C₁-C₁₂alkyl)₂, diphenylamino or 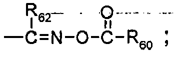 ;
**R₆₅** and **R₆₆** independently of one another are hydrogen, C₁-C₂₀alkyl, C₂-C₄hydroxyalkyl, C₂-C₁₀alkoxyalkyl, C₂-C₅alkenyl, C₃-C₈cycloalkyl, phenyl-C₁-C₃alkyl, C₁-C₈alkanoyl, C₃-C₁₂-alkenoyl, benzoyl; or are phenyl or naphthyl, each of which is unsubstituted or substituted by C₁-C₁₂alkyl, benzoyl or C₁-C₁₂alkoxy; or R₆₅ and R₆₆ together are C₂-C₆alkylene optionally interrupted by O or NR₆₃ and/or optionally substituted by hydroxyl, C₁-C₄alkoxy, C₂-C₄alkanoyloxy or benzoyloxy;
**R₆₇** is C₁-C₁₂alkyl, phenyl or phenyl substituted by C₁-C₁₂alkyl and/or NR₆₅R₆₆;
**R₇₀** and **R₇₁** independently of one another are cyclopentadienyl optionally mono-, di-, or trisubstituted by C₁-C₁₈-alkyl, C₁-C₁₈-alkoxy, cyclopentyl, cyclohexyl or halogen;
**R₇₂** and **R₇₃** are phenyl having at least one F or CF₃ as substituent in ortho position to the Ti-C bond and having at least a further substituent which is unsubstituted pyrrolinyl or polyoxaalkyl or which is pyrrolinyl or polyoxaalkyl substituted by one or two C₁-C₁₂-alkyl, di(C₁-C₁₂-alkyl)aminomethyl, morpholinomethyl, C₂-C₄-alkenyl, methoxymethyl, ethoxymethyl, trimethylsilyl, formyl, methoxy or phenyl; or R₇₂ and R₇₃ are 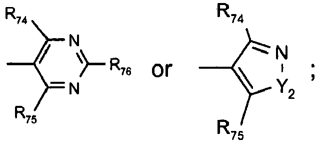 **Y**₂ is O, S, or NR₇₈;
**R₇₄**, **R₇₅** and **R₇₆** independently of one another are hydrogen, halogen, C₂-C₁₂-alkenyl, C₁-C₁₂alkoxy; C₂-C₁₂-alkoxy interrupted by one to four O; cyclohexyloxy, cyclopentyloxy, phenoxy, benzyloxy, unsubstituted phenyl or biphenyl or phenyl or biphenyl substituted by C₁-C₄-alkoxy, halogen, phenylthio or C₁-C₄-alkylthio;
with the proviso that R₇₄ and R₇₅ are not both hydrogen and that with respect to the residue 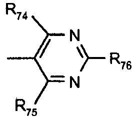 at least one substituent R₇₄ or R₇₅ is C₁-C₁₂alkoxy or C₁-C₁₂alkoxy interrupted by one to four oxygen atoms, cyclohexyloxy, cyclopentyloxy, phenoxy or benzyloxy; and
**R₇₈** is C₁-C₈alkyl, phenyl, cyclopentyl or cyclohexyl.

Such compounds and their preparation are for example disclosed in WO 04/074328 , etc. [=Compounds of formula (I)]; EP 3002, EP 94347, EP 125206, EP 284561, US 4347111, EP 216884, EP 805152, GB 320027, WO 03/040076, WO 04/009651, WO 05/076074, WO05/100292, etc. [=Compounds of formula (II)]; EP 7086, EP 7508, EP 40721, EP 184095, WO 00/32612, etc. [=Compounds of formula (III)]; US 6048660, WO 00/56822, etc. [=Compounds of formula (IV)]; GB 2339571, GB 2358017, WO 02/100903, WO 06/018405, WO 07/071797, etc. [=Compounds of formula (V)]; EP 94915, EP 318894, etc. [=Compounds of formula (VI)]. (The relevant disclosures are the ones with respect to the compounds as such and their preparation).

Specific examples are benzophenone, benzophenone derivatives, such as 2,4,6-trimethylbenzophenone, 2-methylbenzophenone, 3-methylbenzophenone, 4-methylbenzophenone, 2-methoxycarbonylbenzophenone 4,4'-bis(chloromethyl)benzophenone, 4-chlorobenzophenone, 4-phenylbenzophenone, 3,3'-dimethyl-4-methoxy-benzophenone, [4-(4-methylphenylthio)phenyl]-phenylmethanone, methyl-2-benzoylbenzoate, 3-methyl-4'-phenylbenzophenone, 2,4,6-trimethyl-4'-phenylbenzophenone, 4,4'-bis(dimethylamino)benzophenone, 4,4'-bis(diethylamino)benzophenone; ketal compounds, as for example benzyldimethylketal (IRGACURE® 651); acetophenone, acetophenone derivatives, for example α-hydroxycycloalkyl phenyl ketones or α-hydroxyalkyl phenyl ketones, such as for example 2-hydroxy-2-methyl-1-phenyl-propanone (DAROCUR® 1173), 1-hydroxy-cyclohexyl-phenylketone (IRGACURE® 184), 1-(4-dodecylbenzoyl)-1-hydroxy-1-methyl-ethane, 1-(4-isopropyl-benzoyl)-1-hydroxy-1-methyl-ethane, 1-[4-(2-hydroxyethoxy)-phenyl]-2-hydroxy-2-methyl-1-propan-1-one (IRGACURE^{®}2959); 2-hydroxy-1-{4-[4-(2-hydroxy-2-methyl-propionyl)-benzyl]-phenyl}-2-methyl-propan-1-one (IRGACURE®127); 2-hydroxy-1-{4-[4-(2-hydroxy-2-methyl-propionyl)-phenoxy]-phenyl}-2-methyl-propan-1-one; dialkoxyacetophenones, 4-aroyl-1,3-dioxolanes, benzoin alkyl ethers and benzil ketals, e.g. dimethyl benzil ketal, phenylglyoxalic esters and derivatives thereof, e.g. oxo-phenyl-acetic acid 2-(2-hydroxy-ethoxy)-ethyl ester, dimeric phenylglyoxalic esters, e.g. oxo-phenyl-acetic acid 1-methyl-2-[2-(2-oxo-2-phenyl-acetoxy)-propoxy]-ethyl ester (IRGACURE® 754); oxime esters, e.g. 1,2-octanedione 1-[4-(phenylthio)phenyl]-2-(O-benzoyloxime) (IRGACURE® OXE01), ethanone 1-[9-ethyl-6-(2-methylbenzoyl)-9H-carbazol-3-yl]-1-(O-acetyloxime) (IRGACURE® OXE02), 9H-thioxanth-ene-2-carboxaldehyde 9-oxo-2-(O-acetyloxime), peresters, e,g. benzophenone tetracarboxylic peresters as described for example in EP 126541, monoacyl phosphine oxides, e.g. (2,4,6-trimethylbenzoyl)diphenylphosphine oxide (DAROCUR® TPO), ethyl (2,4,6 trimethylbenzoyl phenyl) phosphinic acid ester; bisacylphosphine oxides, e.g. bis(2,6-dimethoxybenzoyl)-(2,4,4-trimethyl-pentyl)phosphine oxide, bis(2,4,6-trimethylbenzoyl)-phenylphos-phine oxide (IRGACURE® 819), bis(2,4,6-trimethylbenzoyl)-2,4-dipentoxyphenylphosphine oxide, trisacylphosphine oxides, halomethyltriazines, e.g. 2-[2-(4-methoxy-phenyl)-vinyl]-4,6-bis-trichloromethyl-[1,3,5]triazine, 2-(4-methoxy-phenyl)-4,6-bis-trichloromethyl-[1,3,5]triazine, 2-(3,4-dimethoxy-phenyl)-4,6-bis-trichloromethyl-[1,3,5]triazine, 2-methyl-4,6-bis-trichloromethyl-[1,3,5]triazine, hexaarylbisimidazole / coinitiators systems, e.g. orthochlorohexaphenyl-bisimidazole combined with 2-mercaptobenzthiazole, ferrocenium compounds, or titanocenes, such as for example bis(cyclopentadienyl)-bis(2,6-difluoro-3-pyrryl-phenyl)titanium (IRGACURE®784). Further, borate compounds can be used as coinitiators. The DAROCUR® and IRGACURE® compounds are registered trademarks of Ciba Inc.

It is evident, that also mixtures of the compounds as described above can be employed as component (d) in the formulations according to the invention.

Preferred as radical initiators (d) are acylphosphine oxides, monoacylphosphine oxides as well as bisacylphosphine oxides, hydroxy ketone compounds and benzophenone and its derivatives.

The photoinitiator component (d) usually is present in the composition of the present invention in amount from 0.001 to 20%, preferably from 0.1 to 10% by weight, based on the composition.

In addition to the photolatent base (a1) or (a2) and component (b) the composition according to the present invention may include various additives (e).

Subject of the invention therefore also is a composition as described above, comprising in addition to components (a1), (b) and (c) and optional (d), or (a2), (b) and (c) and optional (d), or (a3), (b), (c) and optional (d) a further additive (e). As additive (e) in particular a photosensitizer compound is employed.

Additives (e) are for example coinitiators or sensitizers which shift or broaden the spectral sensitivity of the photolatent base compound (a1) or (a2). In general these are aromatic carbonyl compounds, for example benzophenone, thioxanthone, anthraquinone and 3-acylcoumarin and derivatives thereof, or dyes such as for example eosine, rhodamine and erythrosine dyes which improve the overall quantum yield by means, for example, of energy transfer or electron transfer. Examples of suitable dyes which can be added as coinitiators are triarylmethanes, for example malachite green, indolines, thiazines, for example methylene blue, xanthones, thioxanthones, oxazines, acridines or phenazines, for example safranine, and rhodamines of the formula 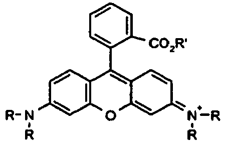 in which R is alkyl or aryl and R' is hydrogen or an alkyl or aryl radical, for example Rhodamine B, Rhodamine 6G or Violamine R, and also Sulforhodamine B or Sulforhodamine G. Likewise suitable are fluorones such as, for example, 5,7-diiodo-3-butoxy-6-fluorone. The person skilled in the art is familiar with suitable compounds of this kind.

Further specific examples of photosensitizers suitable as component (e) are

### 1.Thioxanthones

Thioxanthone, 2-isopropylthioxanthone, 2-chlorothioxanthone, 1-chloro-4-propoxythioxanthone, 2-dodecylthioxanthone, 2,4-diethylthioxanthone, 2,4-dimethylthioxanthone, 1-methoxy-carbonylthioxanthone, 2-ethoxycarbonylthioxanthone, 3-(2-methoxyethoxycarbonyl)-thioxanthone, 4-butoxycarbonylthioxanthone, 3-butoxycarbonyl-7-methylthioxanthone, 1-cyano-3-chlorothioxanthone, 1,3-dimethyl-2-(2-ethylhexyloxy)thioxanthone, 1-ethoxycarbonyl-3-chlorothioxanthone, 1-ethoxycarbonyl-3-ethoxythioxanthone, 1-ethoxycarbonyl-3-aminothioxanthone, 1-ethoxycarbonyl-3-phenylsulfurylthioxanthone, 3,4-di-[2-(2-methoxyethoxy)ethoxy-carbonyl]-thioxanthone, 1,3-dimethyl-2-hydroxy-9Hthioxanthen-9-one 2-ethylhexylether, 1-ethoxycarbonyl-3-(1-methyl-1-morpholinoethyl)-thioxanthone, 2-methyl-6-dimethoxymethyl-thioxanthone, 2-methyl-6-(1,1-dimethoxybenzyl)-thioxanthone, 2-morpholinomethylthioxanthone, 2-methyl-6-morpholinomethylthioxanthone, N-allylthioxanthone-3,4-dicarboximide, N-octylthioxanthone-3,4-dicarboximide, N-(1,1,3,3-tetramethylbutyl)-thioxanthone-3,4-dicarboximide, 1-phenoxythioxanthone, 6-ethoxycarbonyl-2methoxythioxanthone, 6-ethoxycarbonyl-2-methylthioxanthone, thioxanthone-2-carboxylic acid polyethyleneglycol ester, 2-hydroxy-3-(3,4-dimethyl-9-oxo-9H-thioxanthon-2-yloxy)N,N,N-trimethyl-1-propanaminium chloride;

### 2. Benzophenones

benzophenone, 4-phenyl benzophenone, 4-methoxy benzophenone, 4,4'-dimethoxy benzophenone, 4,4'-dimethyl benzophenone, 4,4'-dichlorobenzophenone 4,4'-bis(dimethylamino)-benzophenone, 4,4'-bis(diethylamino)benzophenone, 4,4'-bis(methylethylamino)benzophenone, 4,4'-bis(p-isopropylphenoxy)benzophenone, 4-methyl benzophenone, 2,4,6-trimethylbenzophenone, 4-(4-methylthiophenyl)-benzophenone, 3,3'-dimethyl-4-methoxy benzophenone, methyl-2-benzoylbenzoate, 4-(2-hydroxyethylthio)-benzophenone, 4-(4-tolylthio)-benzophenone, 4,4'-diphenylbenzophenone, 4,4'-diphenoxybenzophenone, 2-methoxycarbonylbenzophenone, 4-benzoyl-4'-methyldiphenyl sulfide, 4-methoxy-3,3'-methylbenzophenone, 1-[4-(4-benzoyl-phenylsulfanyl)-phenyl]-2-methyl-2-(toluene-4-sulfonyl)-propan-1-one, 4-benzoyl-N,N,N-trimethylbenzenemethanaminium chloride, 2-hydroxy-3-(4-benzoylphenoxy)-N,N,N-trimethyl-1-propanaminium chloride monohydrate, 4-(13-acryloyl-1,4,7,10,13-pentaoxatridecyl)-benzophenone, 4-benzoyl-N,N-dimethyl-N-[2-(1-oxo-2-propenyl)oxy]ethyl-benzenemethanaminium chloride;

### 3. Coumarins

Coumarin 1, Coumarin 2, Coumarin 6, Coumarin 7, Coumarin 30, Coumarin 102, Coumarin 106, Coumarin 138, Coumarin 152, Coumarin 153, Coumarin 307, Coumarin 314, Coumarin 314T, Coumarin 334, Coumarin 337, Coumarin 500, 3-benzoyl coumarin, 3-benzoyl-7-methoxycoumarin, 3-benzoyl-5,7-dimethoxycoumarin, 3-benzoyl-5,7-dipropoxycoumarin, 3-benzoyl-6,8-dichlorocoumarin, 3-benzoyl-6-chloro-coumarin, 3,3'-carbonyl-bis[5,7-di(propoxy)-coumarin], 3,3'-carbonyl-bis(7-methoxycoumarin), 3,3'-carbonyl-bis(7-diethylamino-coumarin), 3-isobutyroylcoumarin, 3-benzoyl-5,7-dimethoxy-coumarin, 3-benzoyl-5,7-diethoxy-coumarin, 3-benzoyl-5,7-dibutoxycoumarin, 3-benzoyl-5,7-di(methoxyethoxy)-coumarin, 3-benzoyl-5,7-di(allyloxy)coumarin, 3-benzoyl-7-dimethylaminocoumarin, 3-benzoyl-7-diethylaminocoumarin, 3-isobutyroyl-7-dimethylaminocoumarin, 5,7-dimethoxy-3-(1-naphthoyl)-coumarin, 5,7-diethoxy-3-(1-naphthoyl)-coumarin, 3-benzoylbenzo[f]coumarin, 7-diethylamino-3-thienoylcoumarin, 3-(4-cyanobenzoyl)-5,7-dimethoxycoumarin, 3-(4-cyanobenzoyl)-5,7-dipropoxycoumarin, 7-dimethylamino-3-phenylcoumarin, 7-diethylamino-3-phenylcoumarin, the coumarin derivatives disclosed in JP 09-179299-A and JP 09-325209-A, for example 7-[{4-chloro-6-(diethylamino)-S-triazine-2-yl}amino]-3-phenylcoumarin;

### 4. 3-(aroylmethylene)-thiazolines

3-methyl-2-benzoylmethylene-β-naphthothiazoline, 3-methyl-2-benzoylmethylene-benzothiazoline, 3-ethyl-2-propionylmethylene-β-naphthothiazoline;

### 5. Rhodanines

4-dimethylaminobenzalrhodanine, 4-diethylaminobenzalrhodanine, 3-ethyl-5-(3-octyl-2-benzothiazolinylidene)-rhodanine, the rhodanine derivatives, formulae [1], [2], [7], disclosed in JP 08-305019A;

### 6. Other compounds

acetophenone, 3-methoxyacetophenone, 4-phenylacetophenone, benzil, 4,4'-bis(dimethylamino)benzil, 2-acetylnaphthalene, 2-naphthaldehyde, dansyl acid derivatives, 9,10-anthraquinone, anthracene, pyrene, aminopyrene, perylene, phenanthrene, phenanthrenequinone, 9-fluorenone, dibenzosuberone, curcumin, xanthone, thiomichler's ketone, α-(4-dimethylaminobenzylidene) ketones, e.g. 2,5-bis(4-diethylaminobenzylidene)cyclopentanone, 2-(4-dimethylamino-benzylidene)-indan-1-one, 3-(4-dimethylamino-phenyl)-1-indan-5-yl-propenone, 3-phenylthiophthalimide, N-methyl-3,5-di(ethylthio)-phthalimide, N-methyl-3,5-di(ethylthio)-phthalimide, phenothiazine, methylphenothiazine, amines, e.g. N-phenylglycine, ethyl 4-dimethylaminobenzoate, butoxyethyl 4-dimethylaminobenzoate, 4-dimethylaminoacetophenone, triethanolamine, methyldiethanolamine, dimethylaminoethanol, 2-(dimethylamino)ethyl benzoate, poly(propylenegylcol)-4-(dimethylamino) benzoate.

Likewise suitable in this context are combinations of dyes with borates, as are described, for example, in US 4,772,530, GB 2 307 474, GB 2 307 473, GB 2 307 472 and EP 775 706. The compositions according to the invention may comprise as further additive (e) a photoreducable dye, e.g., xanthene-, benzoxanthene-, benzothioxanthene, thiazine-, pyronine-, porphyrine- or acridine dyes, and/or trihalogenmethyl compounds which can be cleaved by irradiation. Similar compositions are for example described in EP 445624.

Particular preference is given to substituted benzophenones or thioxanthones. Examples of suitable benzophenones are benzophenone, 4,4'-bis(dimethylamino)benzophenone, 4,4'-bis--(diethylamino)benzophenone, 4,4-bis(ethylmethylamino)benzophenone, 4,4'-diphenylbenzophenone, 4,4'-diphenoxybenzophenone, 4,4'-bis(p-isopropylphenoxy)benzophenone, 4-methylbenzophenone, 2,4,6-trimethylbenzophenone, 4-phenylbenzophenone, 2-methoxycarbonylbenzophenone, 4-benzoyl-4'-methyldiphenyl sulfide, 4-methoxy-3,3'-methylbenzophenone, isopropylthioxanthone, chlorothioxanthone, 1-chloro-4-propoxythioxanthone, 2,4-dimethylthioxanthone, 2,4-diethylthioxanthone, 1,3-dimethyl-2-(2-ethylhexyloxy)thioxanthone. Likewise preferred are mixtures of benzophenones and/or thioxanthones such as, for example, a mixture of benzophenone and 4-methylbenzophenone or of 4-methylbenzophenone and 2,4,6-trimethylbenzophenone.

Interesting therefore also is a composition as described above comprising as further additive (e) a photosensitizer compound selected from the group consisting of benzophenone and its derivatives, thioxanthone and its derivatives, anthraquinone and its derivatives or coumarin and its derivatives or dyes such as oxazines, acridines, phenazines and rhodamines, in particular benzophenone and its derivatives, thioxanthone and its derivatives, anthraquinone and its derivatives or coumarin and its derivatives. Examples of the corresponding derivatives are collected in the list above.

Examples of further suitable additives for polymerizable compositions according to the invention include promoters, such as for example a sulfonic acid salt, saccharin, cobalt naphthenate; thermal inhibitors, which are intended to prevent premature polymerization, examples being hydroquinone, hydroquinine derivatives, p-methoxyphenol, ß-naphthol or sterically hindered phenols, such as 2,6-di-tert-butyl-p-cresol.
In order to increase the stability on storage in the dark it is possible, for example, to use copper compounds, such as copper naphthenate, stearate or octoate, phosphorus compounds, for example triphenylphosphine, tributylphosphine, triethyl phosphite, triphenyl phosphite or tribenzyl phosphite, quaternary ammonium compounds, for example tetramethylammonium chloride or trimethylbenzylammonium chloride, or hydroxylamine derivatives, for example N-diethylhydroxylamine.
To exclude atmospheric oxygen during the polymerization it is possible to add paraffin or similar wax-like substances which, being of inadequate solubility in the polymer, migrate to the surface in the beginning of polymerization and form a transparent surface layer which prevents the ingress of air. It is also possible to apply an oxygen-impermeable layer.
Light stabilizers which can be added in a small quantity are UV absorbers, for example those of the hydroxyphenylbenzotriazole, hydroxyphenyl-benzophenone, oxalamide or hydroxyphenyl-s-triazine type. These compounds can be used individually or in mixtures, with or without sterically hindered amines (HALS). Examples of such UV absorbers and light stabilisers are disclosed in WO 04/074328 Case22841, page 12, line 9 to page14, line 23.
It is further possible to add chain transfer agents which are customary in the art to the compositions according to the invention. Examples are mercaptanes and benzothiazol.

Further examples of customary additives (e), depending on the intended use, are optical brighteners, fillers, pigments, dyes, wetting agents, levelling assistants, antistatics, flow improvers, adhesion promoters and antioxidants.

The compositions as additive (e) may also comprise dyes and/or white and colored pigments.
Pigments according to "CD Römpp Chemie Lexikon - Version 1.0, Stuttgart/New York: Georg Thieme Verlag 1995" [CD Römpp Textbook of Chemistry - Version 1.0, Stuttgart/New York: published by Georg Thieme,1995] with hint to DIN 55943 are in the form of particles which in the medium of application are insoluble, anorganic or organic, colored or uncolored coloring means.

Insoluble in this sense is defined as a solubility of less than 1 g / 1000 g of application medium at 25 °C, preferably less than 0.5 g / 1000 g, or less than 0.25g / 1000 g, spceifically less than 0.1 g / 1000 g and in particular less than 0.05 g / 1000 g application medium.

Depending on the kind of application organic as well as anorganic pigments are used. Such additives generally are known to the person skilled in the art.

Examples of pigmentes include any system of absorption- and/or effect pigments, preferably absorption pigments. Number and Selection of such pigment components are not restricted. They can be adjusted to the corresponding needs, as for example the intended color impression. Effect pigments are understood to be pigments, which have a platulet-like composition and exhibit specific decoroative color effects to a surface coating. Effect pigmetns are for example all in vehicle and industry coating usually applied effect-providing pigments. Examples of such effect pigmetns are pure metal pigments, such as aluminum-, iron- or copper pigments; interference pigments, such as mica coated with titanium dioxide, mica coated with iron oxide, mica coated with mixed oxides (e.g. with titanium dioxide and Fe₂O₃ or titanium dioxide and Cr₂O₃), aluminum coated with metal oxide or liquid crystal pigments.

Coloring absorption pigments are for example the organic or anorganic absorption pigments usually employed in coating industry. Examples of organic absorption pigments are azo pigments, phthalocyanine-, Quinacridone- and pyrrolopyrrole pigments.
E.g. mono- or bisazo pigments, as well as metal complexes thereof, phthalocyanine pigments, polycyclic pigments, such as perylene-, anthraquinone-, thioindigo-, chinacridone- or triphenylmethane pigments, as well as diketo-pyrrolo-pyrole-, isoindolinone-, e.g. tetrachlorisoindolinone-, isoindoline-, dioxazin-, benzimidazolone- and chinophthalone pigments.

Examples of anorganic absorption pigments are iron oxide pigments, titanium dioxide and carbon black. Further examples of anorganic pigments are titanium dioxide pigments, e.g. of the rutile type or anatas type, carbon black, zinc oxide, such as zink white, iron oxide, such as iron oxide yellow, iron oxide red, chromium yellow, chromium green, nickel titanium yellow, ultramarine blue, cobalt blue, bismuth vanadate, cadmiumyellow or cadmium red.

Dyes also are suitable coloring agents and are differentiated from the pigments by their solubility in the application medium. That is, at 25 °C, the solubility in the applicaiton medium is more than 1 g / 1000 g application medium.
Examples for dyes are azo-, azin-, anthraquinone-, acridine-, cyanine-, oxazine-, polymethin-, thiazin-, triarylmethane-dyes. These dyes are for example employed as basic or cationic dyes, as etch dyes, direct dyes, dispersion dyes, development dyes, vat dyes, metal complex-, reactive-, acid-, sulfur-, coupling- or substantive dyes.

The pigments and dyes are for example employed alone or in any combination in the compositions according to the invention. Depending on the intended use the pigments are employed in amount customary in the art, for example in an amount of 1-60% by weight, or 10-30% by weight, based on the whole formulation.
Customary concentrations of the organic dyes are for example 0.1-20 %, in particular 1-5 %, based on the whole formulation.

In contrast to the above pigments or dyes as color inert fillers are understood all compounds which on the one hand are non-coloring, that is have a low absorption and whose refractive index is similar to the one of the coating medium and which on the other hand are capable to influence the orientation (parallel alignment) of the effect pigments in the surface coating, that is in the applied coating-film. The more, properties of the coating or the coating compositions, such as hardness or rheology. In the following examples of compounds/components which can be used, without, however, restriciting the expression color-inert filler to said examples. Suitable fillers according to the definition are transparent or semi-transparent fillers or pigments, such as silica gel, diatomite, talcum, calcium carbonate, kaoline, barium sulfate, magnesium silicate, aluminium silicate, crystalline silicon dioxide, amorpheous silicic acid, aluminium oxide, micro capsules or concave micro capsules, e.g. of glass, ceramic or polymers with particle sizes of for example 0.1-50 pm. Other suitable inert fillers are any solid inert organic particles, such as condensation products of urea and formaledehyde, micronized wax of polyolefines and micronized of amide. It is evident that the inert fillers can be used single or in any mixtures depending on the in-tended use of the formulation.

If the composition according to the present invention is used for the preparation of coatings, preferably as further additive a pigment or dye (e.g. selected from the ones as described above) is inserted, usually also a filler (e.g. selected from the ones as described above) is present in such compositions.
Powder coatings are also meant to be covered by the term coating composition in the context of the present invention.

The choice of additive is made depending on the field of application and on properties required for this field. The additives described above are customary in the art and accordingly are added in amounts which are usual in the respective application.

In certain cases it may be of advantage to use mixtures of two or more of the photolatent base compounds (a1) and/or (a2), that is the component (a3).

Redox initiation with the compositions of the present invention can also be combined to a radical photopolymerization initiated by a photoinitiator, or to any other crosslinking reaction, e.g. isocyanate/hydroxyl addition.

The radically polymerizable compound (b) optionally can be admixted for example with basic curable components. Examples of such components are disclosed in WO 03/033500 (see in particular description of component (B) in WO 03/033500, pages 18-23).

The compositions of the invention can be employed for various purposes, for example as printing inks, such as for example flexo-printing inks or inks for sheet-fed printing, as clear-coats, as white paints, for example for wood or metal, as coating materials, inter alia for paper, wood, metal or plastic, as powder coatings, as daylight-curable exterior coatings for marking buildings and roads, for photographic reproduction processes, for holographic recording materials, for image recording processes or for the production of printing plates which can be developed using organic solvents or aqueous-alkaline media, for the production of masks for screen printing, as dental filling materials, as adhesives, including pressure-sensitive adhesives; as laminating resins, as etch resists or permanent resists and as solder masks for electronic circuits, for the production of three-dimensional articles by mass curing (UV curing in transparent moulds) or by the stereolithography process, as is described, for example, in US Patent No. 4,575,330, for the preparation of composite materials (for example styrenic polyesters, which may contain glass fibres and/or other fibres and other assistants) and other thick-layer compositions, for the coating or encapsulation of electronic components, or as coatings for optical fibres.

Of particular interest is the use of the compositions of the invention for preparing decorative coatings, such as exterior coatings on substrates of all kinds, for example buildings, fences, chipboard panels, and as a coating on stone, concrete or metal, for the coating of vehicles, for example, such as cars, railways or aircraft. The compositions may likewise be used in automotive OEM fininshing and automotive refinishing, and also for the finishing of car bodies, plastic parts for cars and body-mounted car parts. The initiators of the invention can be used in a multicoat system in the surfacer, base coat or clearcoat. Their use in pigmented topcoats is also possible.
In surface coatings, it is common to use mixtures of a prepolymer with polyunsaturated monomers which also contain a monounsaturated monomer. The prepolymer here is primarily responsible for the properties of the coating film, and varying it allows the skilled worker to influence the properties of the cured film. The polyunsaturated monomer functions as a crosslinker, which renders the coating film insoluble. The monounsaturated monomer functions as a reactive diluent, by means of which the viscosity is reduced without the need to use a solvent.
The photocurable compositions of the invention are suitable, for example, as coating materials for substrates of all kinds, examples being wood, textiles, paper, ceramic, glass, plastics such as polyesters, polyethylene terephthalate, polyolefins or cellulose acetate, especially in the form of films, and also metals such as Al, Cu, Ni, Fe, Zn, Mg or Co and GaAs, Si or SiO₂, on which it is the intention to apply a protective coating or, by imagewise exposure, an image.
The substrates can be coated by applying a liquid composition, a solution or suspension to the substrate. The choice of solvent and the concentration depend predominantly on the type of composition and the coating process. The solvent should be inert: in other words, it should not undergo any chemical reaction with the components and should be capable of being removed again after the coating operation, in the drying process. Examples of suitable solvents are ketones, ethers and esters, such as methyl ethyl ketone, isobutyl methyl ketone, cyclopentanone, cyclohexanone, N-methylpyrrolidone, dioxane, tetrahydrofurane, 2-methoxyethanol, 2-ethoxyethanol, 1-methoxy-2-propanol, 1,2-dimethoxyethane, ethyl acetate, n-butyl acetate and ethyl 3-ethoxypropionate.
Using known coating processes, the solution is applied uniformly to a substrate, for example by spin coating, dip coating, knife coating, curtain coating, brushing, spraying - especially electrostatic spraying - and reverse roll coating and by electrophoretic deposition. It is also possible to apply the photosensitive layer to a temporary, flexible support and then to coat the final substrate, for example a copper-clad circuit board, by means of layer transfer via lamination.
The amount applied (layer thickness) and the nature of the substrate (layer support) are functions of the desired field of application. The range of layer thicknesses generally comprises values from 0.1 µm to more than 100 µm.

The composition of the present invention can be for example used in adhesive applications. The adhesive composition optionally also contains other additive compounds customary in the art, for example, antioxidants such as for example sterically hindered amines (HALS), phosphites or phenolic antioxidants, filler resins, thickeners, fluidity adjusting agents, plasticizers, defoaming agents and the like.
Such UV-curable adhesives are preferably OH/NCO or SH/NCO systems as described above in blocked or unblocked form. These adhesives are produced by the condensation reaction of an organic polyisocyanate with an active hydrogen-containing compound.

Exposure of the adhesive is for example carried out prior to during or after the lamination, or, in case that the film is not laminated the curing is effected in anaerobic condition. Exposure after the lamination may result in faster curing. Exposure prior to the lamination, for example allows the use of opaque substrates.
Thus, the compositions of the present invention also are suitable in a method of bonding a first substrate to a second substrate, comprising the steps of
(i) applying said composition comprising a photolatent base of the compound of formula (I), (II) or (III) as described above, to at least one transparent surface of at least one of said first and second substrates,
(ii) bringing said first and second substrates together with said adhesive composition there between,
(iii) exposing said adhesive composition to actinic radiation to effect curing.

Further, the compositions of the present invention also are suitable in a method of bonding a first substrate to a second substrate, comprising the steps of
(i) applying said composition comprising a photolatent base of the compound of formula (I), (II) or (III) as described above, to at least one surface of at least one of said first and second substrates,
(iii) exposing said adhesive composition to actinic radiation; and
(ii) bringing said first and second substrates together with said adhesive composition there between.

Examples of the method and components employed therein are given in WO08/009575.

Further, the composition of the present invention can be employed in anaerobic adhesives as for example described in US 6903147.

The compositions according to the present invention also may be employed in a process wherein the composition of matter, is subjected to irradiation before being further processed. Such processes are for example described in WO 06/008251, EP 1002587 and WO 04/069427.

The compositions of the present invention may also be employed as a cement composition as for example disclosed in US 4347174; or also as a dental cement, for example according to the disclosure of EP 49559.

The sensitivity of the compositions to radiation generally extends from 190 nm through the UV region and into the infrared region (20,000 nm, in particular 1200 nm), especially from 190 nm to 650 nm, and therefore spans a very broad range. Suitable radiation is present, for example, in sunlight or light from artificial light sources. Consequently, a large number of very different types of light sources are employed. Both point sources and arrays ("lamp carpets") are suitable. Examples are carbon arc lamps, xenon arc lamps, medium-, super high-, high- and low-pressure mercury lamps, possibly with metal halide dopes (metalhalogen lamps), microwave-stimulated metal vapour lamps, excimer lamps, superactinic fluorescent tubes, fluorescent lamps, argon incandescent lamps, electronic flashlights, photographic flood lamps, electron beams and X-rays. The distance between the lamp and the substrate to be exposed in accordance with the invention may vary depending on the intended application and the type and output of lamp, and may be, for example, from 2 cm to 150 cm. Laser light sources, for example excimer lasers, such as krypton F lasers for exposure at 248 nm are also suitable. Lasers in the visible region can also be employed. Alternatively, the actinic radiation is provided by light emitting diodes (LED), such as for example organic light emitting diodes (OLED), e.g. UV light emitting diodes (UV-LED). Said LEDs allow instant on and off switching of the radiation source. Further, UV-LEDs generally have a narrow wavelength distribution and offer the possibility to customize the peak wavelength and also provide an efficient conversion of electric energy to UV radiation.

Depending on the light source used it is advantageous in many cases to employ a sensitizer, as described above, whose absorption spectrum coincides as closely as possible to the emission spectrum of the radiation source.

The present invention also pertains to the use of a compound of the formula I as defined above for the UV-curing of compositions comprising a radically polymerizable compound (b); and a peroxide (c); as well as to a process for crosslinking a radically polymerizable compound (b), by admixing said component with a photolatent base catalyst of the formula I as defined above and (c) a peroxide, and irradiating the composition with light of a wavelength range of 200-650 nm.
A further subject of the invention os a process for crosslinking a radically polymerizable compound as described above, wherein a thermal treatment is carried out prior, during or after the irradiation.
Subject of the invention moreover is the use of the composition as described above for the preparation of adhesives, coatings, sealings, potting components, printing inks, moulding compounds, or photostructured layers; as well as a process as decribed above for the preparation of adhesives, coatings, sealings, potting components, printing inks, moulding compounds, or photostructured layers.
Another embodiment of the invention is a coated substrate coated on at least one surface with a composition as described above; as well as a polymerized or crosslinked composition as described above.

The examples which follow illustrate the invention in more detail, without restriciting the scope claims. Parts and percentages are, as in the remainder of the description and in the claims, by weight, unless stated otherwise. Where alkyl radicals having more than three carbon atoms are referred to in the examples without any mention of specific isomers, the n-isomers are meant in each case.

### A/ Polyurethane acrylate formulation:

### Example 1:

A uv-curable formulation is prepared by mixing the following components:

| | | |
|---|---|---|
| 0.10 g | of the photolatent amidine | 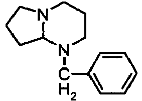 |
| 0.10 g | of isopropylthioxanthone as sensitizer; DAROCUR® ITX, provided by Ciba Specialty Chemicals | |
| 0.10 g | of methyl ethyl ketone peroxide as thermal radical initiator, provided by Aldrich | |
| 0.18 g | of 2,4,6-trimethylbenzoyl-diphenyl phosphine oxide as radical photoinitiator; DAROCUR® TPO, provided by Ciba Specialty Chemicals | |
| 0.02 g | of a silicone surface additive, Byk 306, provided by Byk Chemie | |
| 1.00 g | of a hexafunctional aliphatic urethane acrylate, Ebecryl 1290, provided by Cytec | |
| 5.80 g | of a urethane-acrlyate oligomer, Ebecryl 4858, provided by Cytec | |
| 3.00 g | of a 7:3 mixture of butyl acetate/xylene as solvent | |

The formulation is applied onto a BaF₂ crystal and laminated with a polypropylene film which is transparent to UV radiation. The sample is exposed for 30 s to UVB and UVA light (Philips TL40W/05). The IR spectra are measured before and after light exposure so as to determine the acrylate cure extent. The reaction extent is followed by monitoring the acrylate peak at 810 cm⁻¹. The same experiment is repeated without lamination. The following table 1 summarizes the result.

**Table 1**

| **Acrylate conversion (%) Laminate** | **Acrylate conversion (%) Non-laminate** |
|---|---|
| 77 | 18 |

These results show that UV light can readily activate the redox cure initiation of acrylates in the absence of oxygen. The reaction is strongly inhibited by oxygen, which is a typical feature for redox reactions.
The formulation is stable for several days in the flask.

### Examples 2-6:

In the examples 2-6 Composition PART A, composed of

| | |
|---|---|
| 1.00 g | of a hexafunctional aliphatic urethane acrylate, Ebecryl 1290, provided by Cytec |
| 5.80 g | of a urethane-acrlyate oligomer, Ebecryl 4858, provided by Cytec |
| 3.00 g | of a 7:3 mixture of butyl acetate/xylene as solvent |
| 0.02 g | of a silicone surface additive, Byk 306, provided by Byk Chemie |

is admixed with Composition Part B2-B6 as defined below

### Composition of PART B2

| | | |
|---|---|---|
| 0.10g | of the photolatent amidine | 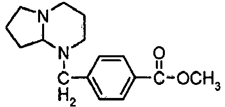 |
| 0.10g | of isopropylthioxanthone as sensitizer, DAROCUR® ITX, provided by Ciba Inc | |
| 0.20g | of 2-butanone peroxide (methyl ethyl ketone peroxide) 50-60% in plasticizer as thermal radical initiator, provided by Fluka | |
| 0.18g | of 2,4,6-trimethylbenzoyl-diphenyl phosphine oxide as radical photoinitiator; (DAROCUR® TPO) provided by Ciba Inc. | |

### Composition of PART B3

| | | |
|---|---|---|
| 0.10g | of the photolatent amidine | 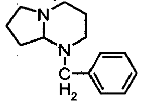 |
| 0.10g | of isopropylthioxanthone as sensitizer, DAROCUR® ITX, provided by Ciba Inc | |
| 0.10g | of dibenzoyleperoxide peroxide as thermal radical initiator, provided by Fluka | |
| 0.18g | of 2,4,6-trimethylbenzoyl-diphenyl phosphine oxide as radical photoinitiator, DAROCUR® TPO, provided by Ciba Inc. | |

### Composition of PART B4

| | | |
|---|---|---|
| 0.10g | of the photolatent amidine | 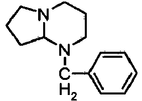 |
| 0.10g | of isopropylthioxanthone as sensitizer, DAROCUR® ITX, provided by Ciba Inc | |
| 0.10g | of dibenzoyleperoxide peroxide as thermal radical initiator, provided by Fluka | |

### Composition of PART B5

| | | |
|---|---|---|
| 0.10g | of the photolatent amidine | 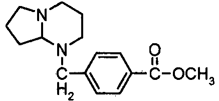 |
| 0.10g | of isopropylthioxanthone as sensitizer, DAROCUR® ITX, provided by Ciba Inc | |
| 0.20g | of 2-butanone peroxide (methyl ethyl ketone peroxide) 50-60% in plasticizer as thermal radical initiator, provided by Fluka | |

### Composition of PART B6

| | | |
|---|---|---|
| 0.10g | of the photolatent amine | 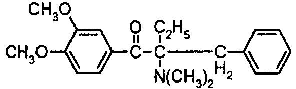 |
| 0.10g | of 2-butanone peroxide (methyl ethyl ketone peroxide) 50-60% in plasticizer as thermal radical initiator, provided by Fluka | |

The formulations comprising Composition PART A and Composition PART B2-B6, respectively, are applied on two BaF₂ crystals with a 12µm calibrated wirewound bar coater. One sample is covered by a BOPP film ("laminated"), which is transparent to the UV radiations, in order to prevent, or at least significantly reduce oxygen inhibition (radical scavenger). A second sample is not laminated and consequently exposed to the air. Both samples are exposed for 30s to UVB and UVA light provided by 6 lamps TL actinic from Phillips. The acrylate conversion and therefore the cure efficiency are determined by IR spectroscopy before and after light exposure. The acrylate peak at 1636cm⁻¹ is monitored by means of FTIR analysis. The higher the acrylate conversion, the better is the curing efficiency.
The results from FTIR analysis for examples 2 to 6 are presented in the table 2:

**Table 2:**

| | Acrylate conversion (%) laminated | Acrylate conversion (%) Non-laminated |
|---|---|---|
| Example 2 | 88 | 59 |
| Example 3 | 95 | 69 |
| Example 4 | 86 | 59 |
| Example 5 | 94 | 37 |
| Example 6 | 86 | 36 |

The results show that UV light can readily activate the redox initiation process of acrylate polymerization. This can be achieved for all the 3 types of photolatent bases in the presence of various peroxides, and with as well as without the presence of a free radical photointitiator.

As expected, higher conversion is achieved when the film is protected ("laminated") from the influence of oxygen.

### B/ Aminoacrylate formulation

### Example 7

The following components are mixed:

| | | |
|---|---|---|
| 0.075g | of the photolatent amidine | 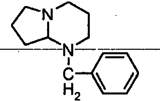 |
| 0.075g | of isopropylthioxanthone as sensitizer, DAROCUR® ITX, provided by Ciba Inc | |
| 0.075g | of dibenzoyleperoxide peroxide as thermal radical initiator, provided by Fluka | |
| 5.00g | of an amine- modified acrylate, Ebecryl 83, provided by Cytec | |
| 2.00 g | of a 7:3 mixture of butyl acetate/ xylene as solvent. | |
| 0.02g | of silicone surface additives, Byk306, provided by Byk Chemie | |

The formulation is applied on two BaF₂ crystals with a 12µm calibrated wirewound bar coater. One sample is covered by a BOPP film ("laminate"), which is transparent to the UV radiations, in order to prevent, or at least significantly reduce oxygen inhibition (radical scavenger). A second sample is not laminated and consequently exposed to the air. Both samples are exposed for 30s to UVB and UVA light provided by 6 lamps TL actinic from Phillips. The acrylate conversion and therefore the cure efficiency are determined by IR spectroscopy before and after light exposure. The acrylate peak at 1636cm⁻¹ is monitored by means of FTIR analysis. The higher the acrylate conversion, the better is the curing efficiency. The results from FTIR analysis for example 7 are presented in the table 3:

**Table 3:**

| | laminated | Non-laminated |
|---|---|---|
| Acrylate conversion (%) | 92 | 87 |

The results show that UV light can readily activate the redox initiation process of acrylate polymerization. For this formulation based on an amino-acrylate, the results also show that there is almost no oxygen inhibition.

### C/ Polyester acrylate formulation

In the following examples 8 to 11 the formulations are prepared by adding catalysts and initiators (Part B) in a polyester acrylate coatings system (Part A1).

### Composition of PART A1:

| | |
|---|---|
| 6.00g | of a polyesther acrylate, Ebecryl 830, provided by Cytec |
| 3.00g | of a 7:3 mixture of butyl acetate/ xylene as solvent |
| 0.02g | of silicone surface additives, Byk306, provided by Byk Chemie |

### Composition of PART B8

| | | |
|---|---|---|
| 0.10g | of the photolatent amidine | 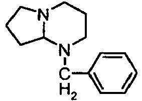 |
| 0.10g | of isopropylthioxanthone as sensitizer, DAROCUR® ITX, provided by Ciba Inc | |
| 0.10g | of 2-butanone peroxide (methyl ethyl ketone peroxide) 50-60% in plasticizer as thermal radical initiator, provided by Fluka | |
| 0.18g | of 2,4,6- trimethylbenzoyl-diphenyl phosphine oxide as radical photoinitiator; (DAROCUR® TPO) provided by Ciba Inc, | |

### Composition of PART B9

| | | |
|---|---|---|
| 0.10g | of the photolatent amidine | 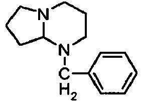 |
| 0.10g | of isopropylthioxanthone as sensitizer, DAROCUR® ITX, provided by Ciba Inc | |
| 0.10g | of 2-butanone peroxide (methyl ethyl ketone peroxide) 50-60% in plasticizer as thermal radical initiator, provided by Fluka | |

### Composition of PART B10

| | | |
|---|---|---|
| 0.10g | of the photolatent amine | 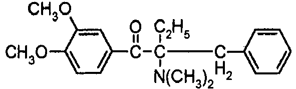 |
| 0.10g | of 2-butanone peroxide (methyl ethyl ketone peroxide) 50-60% in plasticizer as thermal radical initiator, provided by Fluka | |
| 0.18g | of 2,4,6-trimethylbenzoyl-diphenyl phosphine oxide as radical photoinitiator; (DAROCUR® TPO), provided by Ciba Inc, | |

### Composition of PART B11

| | | |
|---|---|---|
| 0.10g | of the photolatent amine | 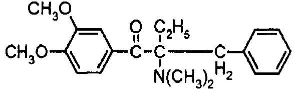 |
| 0.10g | of 2-butanone peroxide (methyl ethyl ketone peroxide) 50-60% in plasticizer as thermal radical initiator, provided by Fluka | |

The formulations are applied on two BaF₂ crystals with a 12µm calibrated wirewound bar coater. One sample is covered by a BOPP film ("laminate"), which is transparent to the UV radiations, in order to prevent, or at least significantly reduce oxygen inhibition (radical scavenger). A second sample is not laminated and consequently exposed to the air. Both samples are exposed for 30s to UVB and UVA light provided by 6 lamps TL actinic from Phillips. The acrylate conversion and therefore the cure efficiency are determined by IR spectroscopy before and after light exposure. The acrylate peak at 1636cm⁻¹ is monitored by means of FTIR analysis. The higher the acrylate conversion, the better is the curing efficiency. The results from FTIR analysis for examples 8 to 11 are presented in the table 4:

**Table 4:**

| | Acrylate conversion (%) laminated | Acrylate conversion (%) Non-laminated |
|---|---|---|
| Example 8 | 80 | 38 |
| Example 9 | 77 | 21 |
| Example 10 | 96 | 40 |
| Example 11 | 95 | 22 |

The results show that UV light can readily activate the redox initiation process of acrylate polymerization. For this formulation based on polyester-acrylate, the results also show that oxygen inhibition is somewhat more pronounced than for the urethane-acrylate. On the other hand, according to the acrylate conversion data, the efficiency of the radical generation seems better in the case of the photolatent tertiay amine than for the photolatent amidine.

## Claims

1. A composition comprising
(a1) a photolatent amidine base; or
(a2) a photolatent amine base; or
(a3) a mixture of (a1) and (a2); and
(b) a radically polymerizable compound; and
(c) a peroxide.

2. A composition according to claim **1,** additionally to components (a1) or (a2) or (a3), (b) and
(c) comprising
(d) an initiator which is capable of curing (b).

3. A composition according to claim **1** or **2,** wherein the base (a1) or (a2) is a photolatent base compound of the formula I,
Z-A (I),
wherein
**Z** is a photolabile group; and
**A** is a base precursor group, covalently bonded to Z.

4. A composition according to claim 1, wherein the photolatent amidine base (a1) is a compound of the formula (II) 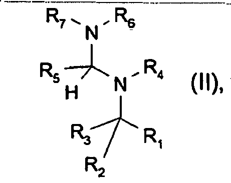 wherein
**R₁** is an aromatic or heteroaromatic radical which is capable of absorbing light in the wavelength range from 200 to 650 nm and which is unsubstituted or substituted by one or more C₁-C₁₈-alkyl, C₂-C₁₈-alkenyl, C₂-C₁₈-alkinyl, C₁-C₁₈-haloalkyl, NR₈R₉, CN, OR₁₀, SR₁₀, COR₁₁, COOR₁₂, halogen or 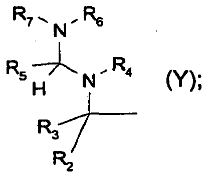 o is an integer from 1 to15;
**R₄₀** is C₁-C₈-alkyl, C₃-C₅-alkenyl, phenyl-C₁-C₃-alkyl, C₁-C₄-hydroxyalkyl or phenyl;
**R₄₁** is C₂-C₁₆-alkylene which optionally is interrupted by one or more O or S;
**R₄₂** is C₁-C₁₈-alkyl, naphthyl or phenyl which is unsubstituted or substituted by halogen, C₁-C₁₂-alkyl and/or C₁-C₈-alkoxy; and
**R₄₃** is C₁-C₈-alkyl, phenyl-C₁-C₃-alkyl, CH₂CH₂-COO(C₁-C₈-alkyl), CH₂CH₂CN, CH₂CH₂-COO(CH₂CH₂O)ₒ-H or

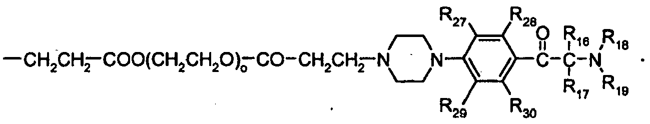

5. A composition according to claim 1 wherein the component (a1) is a compound 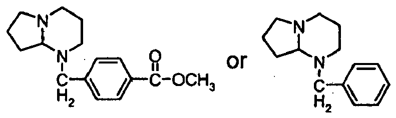 and component (a2) is the compound

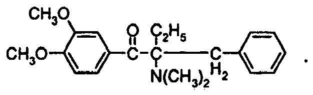

6. A composition according to anyone of claims 1 to 6, comprising in addition to components (a1), (b) and (c) and optional (d), or (a2), (b) and (c) and optional (d), or (a3), (b), (c) and optional (d) a further additive (e).

7. A composition according to claim 1, wherein component (a1) or (a2) or (a3) is present in an amount of from 0.01 to 20% by weight, based on the total composition.

8. Use of a photolatent amidine or amine base compound of the formula I as defined in claim 3 for the UV-curing of compositions comprising (b) a radically polymerizable compound; and (c) a peroxide.

9. A process for crosslinking a radically polymerizable compound (b), by admixing said component with a photolatent amidine or amine base catalyst of the formula I as defined in claim 3 and (c) peroxide and irradiating the composition with light of a wavelength range of 200-650 nm.

## Patentansprüche

1. Zusammensetzung, umfassend
(a1) eine photolatente Amidinbase; oder
(a2) eine photolatente Aminbase; oder
(a3) eine Mischung von (a1) und (a2); und
(b) eine radikalisch polymerisierbare Verbindung; und
(c) ein Peroxid.

2. Zusammensetzung nach Anspruch 1, die zusätzlich zu den Komponenten (a1) bzw. (a2) bzw. (a3), (b) und (c)
(d) einen Initiator, der zur Härtung von (b) befähigt ist, umfasst.

3. Zusammensetzung nach Anspruch 1 oder 2, wobei es sich bei der Base (a1) oder (a2) um eine photolatente Basenverbindung der Formel I,
Z-A (I),
worin
Z für einen photolabile Gruppe steht; und
A für eine Basenvorläufergruppe, die kovalent an Z gebunden ist, steht;
handelt.

4. Zusammensetzung nach Anspruch 1, wobei es sich bei der photolatenten Amidinbase (a1) um eine Verbindung der Formel (II) 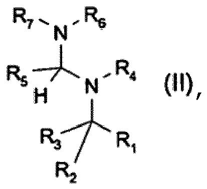 worin
R₁ für einen zur Lichtabsorption im Wellenlängenbereich von 200 bis 650 nm befähigten aromatischen oder heteroaromatischen Rest steht, der unsubstituiert oder durch ein oder mehrere C₁-C₁₈-Alkyl, C₂-C₁₈-Alkenyl, C₂-C₁₈-Alkinyl, C₁-C₁₈-Halogenalkyl, NR₈R₉, CN, OR₁₀, SR₁₀, COR₁₁, COOR₁₂, Halogen oder 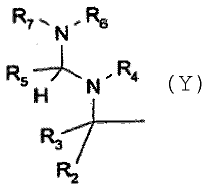 substituiert ist;
o für eine ganze Zahl von 1 bis 15 steht;
R₄₀ für C₁-C₈-Alkyl, C₃-C₅-Alkenyl, Phenyl-C₁-C₃-alkyl, C₁-C₄-Hydroxyalkyl oder Phenyl steht;
R₄₁ für C₂-C₁₆-Alkylen, das gegebenenfalls durch ein oder mehrere 0 oder S unterbrochen ist, steht;
R₄₂ für C₁-C₁₈-Alkyl, Naphthyl oder Phenyl, das unsubstituiert oder durch Halogen, C₁-C₁₂-Alkyl und/oder C₁-C₈-Alkoxy substituiert ist, steht; und R₄₃ für C₁-C₈-Alkyl, Phenyl-C₁-C₃-alkyl, CH₂CH₂-COO(C₁-C₈-Alkyl), CH₂CH₂CN, CH₂CH₂-COO(CH₂CH₂O)ₒ-H
oder 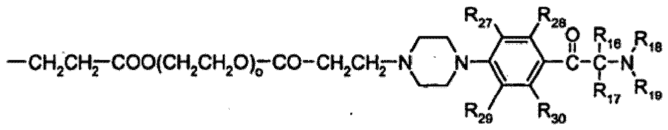 steht;
handelt.

5. Zusammensetzung nach Anspruch 1, wobei es sich bei der Komponente (a1) um eine Verbindung 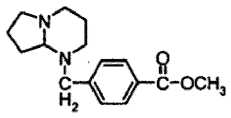 oder 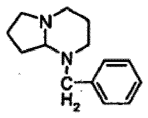 handelt und es sich bei der Komponente (a2) um die Verbindung 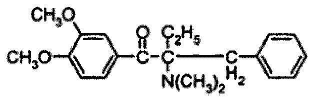 handelt.

6. Zusammensetzung nach einem der Ansprüche 1 bis 6, die neben den Komponenten (a1), (b) und (c) und gegebenenfalls (d) bzw. (a2), (b) und (c) und gegebenenfalls (d) bzw. (a3), (b) und (c) und gegebenenfalls (d) ein weiteres Additiv (d) umfasst.

7. Zusammensetzung nach Anspruch 1, bei dem die Komponente (a1) bzw. (a2) bzw. (a3) in einer Menge von 0,01 bis 20 Gew.-%, bezogen auf die gesamte Zusammensetzung, vorliegt.

8. Verwendung einer photolatenten Amidin- oder Aminbasenverbindung der Formel I gemäß Anspruch 3 zur UV-Härtung von Zusammensetzungen, die (b) eine radikalisch polymerisierbare Verbindung und (c) ein Peroxid umfassen.

9. Verfahren zum Vernetzen eine radikalisch polymerisierbaren Verbindung (b) durch Mischen der Komponente mit einem photolatenten Amidin- oder Aminbasenkatalysator der Formel I gemäß Anspruch 3 und (c) Peroxid und Bestrahlen der Zusammensetzung mit Licht eines Wellenlängenbereichs von 200-650 nm.

## Revendications

1. Composition comprenant
(a1) une base amidine photolatente ; ou
(a2) une base amine photolatente ; ou
(a3) un mélange de (a1) et (a2) ; et
(b) un composé polymérisable par voie radicalaire ; et
(c) un peroxyde.

2. Composition selon la revendication 1, comprenant en plus des composants (a1) ou (a2) ou (a3), (b) et (c) (d) un initiateur qui est susceptible de durcir (b).

3. Composition selon la revendication 1 ou 2, dans laquelle la base (a1) ou (a2) est un composé basique photolatent de formule I
Z-A (I),
dans laquelle
Z est un groupe photolabile ; et
A est un groupe précurseur de base, lié de façon covalente à Z.

4. Composition selon la revendication 1, dans laquelle la base amidine photolatente (a1) est un composé de formule (II) 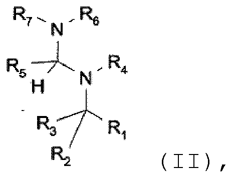 dans laquelle **R₁** est un radical aromatique ou hétéroaromatique qui est susceptible d'absorber la lumière dans la gamme de longueurs d'onde de 200 à 650 nm et qui est non substitué ou substitué par un ou plusieurs groupes alkyle en C₁-C₁₈, alcényle en C₂-C₁₈, alcynyle en C₂-C₁₈, halogénoalkyle en C₁-C₁₈, NR₈R₉, CN, OR₁₀, SR₁₀, COR₁₁,
COOR₁₂, halogéno ou 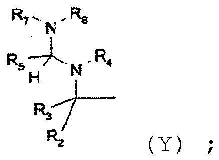 o est un entier de 1 à 15 ;
**R₄₀** est un groupe alkyle en C₁-C₈, alcényle en C₃-C₅, phényl-alkyle en C₁-C₃, hydroxyalkyle en C₁-C₄ ou phényle ;
**R₄₁** est un alkylène en C₂-C₁₆ qui est éventuellement interrompu par un ou plusieurs 0 ou S ;
**R₄₂** est un groupe alkyle en C₁-C₁₈, naphtyle ou phényle qui est non substitué ou substitué par un halogène, un alkyle en C₁-C₁₂ et/ou un alcoxy en C₁-C₈ ; et
**R₄₃** est un groupe alkyle en C₁-C₈, phényl-alkyle en C₁-C₃, CH₂CH₂-COO (alkyle en C₁-C₈), CH₂CH₂CN, CH₂CH₂-COO(CH₂CH₂O)ₒ-H
ou

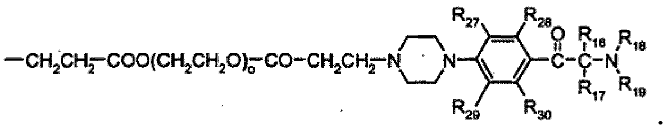

5. Composition selon la revendication 1, dans laquelle le composant (a1) est un composé 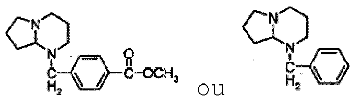 et le composant (a2) est le composé

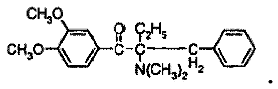

6. Composition selon l'une quelconque des revendications 1 à 6, comprenant, en plus des composants (a1), (b) et (c) et éventuellement (d), ou (a2), (b) et (c) et éventuellement (d), ou (a3), (b) et (c) et éventuellement (d), un autre additif (e).

7. Composition selon la revendication 1, dans laquelle le composant (a1) ou (a2) ou (a3) est présent dans une quantité de 0,01 à 20 % en poids de la composition totale.

8. Utilisation d'un composé basique amidine ou amine photolatent de formule I tel que défini dans la revendication 3 pour le durcissement aux UV de compositions comprenant (b) un composé polymérisable par voie radicalaire, et (c) un peroxyde.

9. Procédé de réticulation d'un composé polymérisable par voie radicalaire (b), par mélange dudit composant avec un catalyseur basique amidine ou amine photolatent de formule I tel que défini dans la revendication 3 et (c) un peroxyde, et irradiation de la composition avec une lumière d'une gamme de longueurs d'onde de 200-650 nm.
